# EUROPEAN PATENT APPLICATION

(11) **EP 2 034 514 A1**
(43) Date of publication of application: **11.03.2009**
(21) Application number: 07743845.5
(22) Date of filing: 22.05.2007
(51) Int. Cl.: H01L 21/027, G03F 7/20

(54) **EXPOSURE METHOD AND APPARATUS, MAINTENANCE METHOD, AND DEVICE MANUFACTURING METHOD**

(30) Priority: 22.05.2006 JP 2006141024; 23.05.2006 JP 2006143452
(71) Applicant: Nikon Corporation, Tokyo 100-8331 (JP)
(72) Inventor: NAKANO, Katsushi, Tokyo 100-8331 (JP)
(74) Representative: HOFFMANN EITLE
(86) International application number: PCT/JP2007/060411
(87) International publication number: WO 2007/136052

(57) **Abstract**

An exposure method for exposing a substrate P with an exposure light EL via an projection optical system PL and a liquid 1 includes: a first step of optically observing a liquid contact portion which comes into contact with the liquid 1 and storing first image data obtained by the optical observation; a second step of optically observing the liquid contact portion after the liquid contact portion came into contact with the liquid 1, for example, after the liquid immersion exposure and obtaining second image data obtained by the optical observation; and a third step of comparing the first image data and the second image data to judge whether abnormality of observation objective portion is present or absent. It is possible to efficiently judge whether or not the abnormality of the liquid-contact portion, of the exposure apparatus which performs the exposure by the immersion method, is present or absent.

## Description

### TECHNICAL FIELD

The present invention relates to an exposure technique for exposing a substrate with an exposure light through a liquid, a maintenance technique for an exposure apparatus using the exposure technique, and a technique for producing a device using the exposure technique.

### BACKGROUND ART

A microdevice (electronic device), which includes a semiconductor device, a liquid crystal display device, etc. is produced by the so-called photolithography technique wherein a pattern, which is formed on a mask such as a reticle, is transferred onto a substrate such as a wafer which is coated with a photosensitive material such as a resist (photoresist). In order to transfer the pattern on the mask onto the substrate via a projection optical system in the photolithography step, those used are an exposure apparatus (so-called stepper) of the reduction projection type based on the step-and-repeat system and an exposure apparatus (so-called scanning stepper) of the reduction projection type based on the step-and-scan system.

As for the exposure apparatus of this type, it has been carried out to shorten the wavelength of the exposure light and increase the numerical aperture (NA) of the projection optical system (realize the large NA) in order to respond to such a request that the higher resolution (resolving power) is demanded year by year as the pattern becomes fine and minute in accordance with the realization of the high integration of the semiconductor device or the like. However, when the wavelength of the exposure light is shortened and NA is increased, then the resolution of the projection optical system is improved, while the depth of focus is consequently decreased and narrowed. Therefore, if such a situation is continued, then the depth of focus is too narrowed and it is feared that the focus margin may be insufficient during the exposure operation.

In view of the above, an exposure apparatus, which utilizes the liquid immersion method, has been developed in order to provide such a method that the exposure wavelength is substantially shortened and the depth of focus is widened as compared with those obtained in the air (see, for example, International Publication No. 99/49504). In the liquid immersion method, the exposure is performed in such a state that a liquid immersion area is formed by filling a space between the lower surface of the projection optical system and the substrate surface with a liquid including water, organic solvents, or the like. Accordingly, the resolution can be improved and the depth of focus can be magnified about n times by utilizing the fact that the wavelength of the exposure light is 1/n-fold in the liquid as compared with the wavelength in the air (n represents the refractive index of the liquid, which is, for example, about 1.2 to 1.6).

### DISCLOSURE OF THE INVENTION

### Task to Be Solved by the Invention:

In a case that the exposure process is performed by using the liquid immersion method as described above, the exposure is performed for the substrate while supplying the liquid to the liquid immersion area formed between the projection optical system and the substrate from a certain or predetermined liquid supply mechanism, and the liquid of the liquid immersion area is recovered by a certain or predetermined liquid recovery mechanism. However, it is feared that any minute foreign matter (particles) including the resist residue, etc. might adhere during the exposure based on the liquid immersion method to a portion which comes into contact with the liquid, for example, a portion which comes into contact with the liquid including the flow passages for the liquid of the liquid supply mechanism and the liquid recovery mechanism, etc. There is such a possibility that the foreign matter, which adheres as described above, enters into and mixed with the liquid again and adheres to the surface of the substrate as the exposure objective during the exposure to be performed thereafter, and the foreign matter may become any factor of the defect such as the shape deficiency or unsatisfactory shape of the pattern to be transferred.

Therefore, it is desirable to judge whether or not the foreign matter, which may become the factor of the shape deficiency or the like, adheres to at least a part of the portion which comes into contact with the liquid, for example, periodically while hardly lowering the throughput of the exposure step (rate of operation of the exposure apparatus).

Recently, various resists have been developed in order to improve the resolution, the sensitivity, etc. The surface of the resist is sometimes coated with, for example, a top coat for avoiding the reflection and/or protecting the resist. Novel materials have been newly developed for the top coat or the like as well. However, it is feared for some of such materials that any shape error or the like may be caused at the stage of the resist pattern in the case of the exposure based on the liquid immersion method, although no problem arises in the case of the dry exposure. If the concerning material is revealed to be inadequate or unsuitable for the liquid immersion method after actually performing the exposure step and the developing step as described above, then the exposure step or the like turns out to be vain or useless, and thus the throughput of the device production is lowered.

On the other hand, when the resist, the top coat film or the like involves any abnormality (for example, uneven thickness), if the exposure is performed by the liquid immersion method, then it is feared that the exfoliation or the like might easily occur due to the contact with the liquid, and any shape error or the like might be caused at the stage of the resist pattern. Therefore, if the liquid immersion exposure is performed while allowing the state of the film to still involve any abnormality, it is feared that the exposure step and the following steps might turn out to be useless.

Taking the foregoing circumstances into consideration, a first object of the present invention is to provide an exposure technique, a maintenance technique, and a technique for producing a device wherein it is possible to efficiently judge whether or not any abnormality is present in any portion which is included in an exposure apparatus for performing the exposure by the liquid immersion method and which comes into contact with the liquid, i.e., whether or not any foreign matter, which has a fear of becoming the factor for shape deficiency or the like of a pattern to be transferred, adheres to such portion which comes into contact with the liquid. A second object of the present invention is to provide an exposure technique and a technique for producing a device wherein it is possible to judge, without actually performing the exposure, whether or not the state of a substrate as an exposure objective is adequate or suitable for the exposure based on the liquid immersion method.

### Solution for the Task:

According to a first aspect of the present invention, there is provided an exposure method for exposing a substrate (P) with an exposure light (EL) via an optical member (2) and a liquid (1), the exposure method comprising: a first step (S1, S2) of storing first observation information obtained by optically observing a state of at least a part of a detection objective portion (68A to 68D, 25) of a liquid contact portion which comes into contact with the liquid in a predetermined operation; a second step (S4, S5) of obtaining second observation information by optically observing a state of the detection objective portion after the predetermined operation; and a third step (S6, S7) of comparing the first observation information and the second observation information to judge whether abnormality of the detection objective portion is present or absent.

According to the first aspect of the present invention, it is possible to efficiently judge whether or not a foreign matter, which exceeds a predetermined allowable range, adheres to the detection objective portion (liquid contact portion), and consequently it is possible to judge whether the abnormality is present or absent, by merely comparing the second observation information obtained after the exposure with the first observation information obtained in the state that no foreign matter adheres before the exposure. The exposure method according to the first aspect of the present invention may further comprise a fourth step of stopping an exposure operation when the abnormality is present in the third step. Accordingly, it is possible to reduce the probability of the entering and mixing of the foreign matter into and with the liquid during the exposure to be performed thereafter by the liquid immersion method.

According to a second aspect of the present invention, there is provided an exposure method for exposing a substrate (P) with an exposure light (EL) via an optical member (2) and a liquid (1), the exposure method comprising: detecting information about a state of a liquid contact portion (68A to 68D, 25) which comes into contact with the liquid in a predetermined operation; and detecting information about abnormality of the liquid contact portion based on the detected information about the state and reference information about a state of the liquid contact portion before the predetermined operation.

According to a third aspect of the present invention, there is provided an exposure apparatus which exposes a substrate (P) with an exposure light (EL) via an optical member (2) and a liquid (1), the exposure apparatus comprising: an optical device (ALG, 65) which optically observes a state of at least a part of a detection objective portion (68A to 68D, 25) of a liquid contact portion which comes into contact with the liquid; a storage device (58) which stores observation information obtained by the optical device; and a controller (57, CONT) which compares a plurality of pieces of the observation information obtained by observing the detection objective portion a plurality of times by the optical device (ALG, 65) to judge whether abnormality of the detection objective portion is present or absent.

According to a fourth aspect of the present invention, there is provided an exposure apparatus which exposes a substrate (P) with an exposure light (EL) via an optical member (2) and a liquid (1), the exposure apparatus comprising: an optical device (ALG, 65) which detects information about a state of a liquid contact portion (68A to 68D, 25) which comes into contact with the liquid in a predetermined operation; and a controller (57) which detects information about abnormality of the liquid contact portion based on the detected information about the state and reference information about a state of the liquid contact portion before the predetermined operation.

According to a fifth aspect of the present invention, there is provided a maintenance method for an exposure apparatus which exposes a substrate (P) with an exposure light (EL) via an optical member (2) and a liquid (1), the maintenance method comprising: detecting information about a state of a liquid contact portion (68A to 68D, 25) which comes into contact with the liquid in a predetermined operation; and detecting information about abnormality of the liquid contact portion based on the detected information about the state and reference information about a state of the liquid contact portion before the predetermined operation.

According to a sixth aspect of the present invention, there is provided an exposure method for exposing a substrate (P) with an exposure light (EL) through a liquid (1), the exposure method comprising: a first step (part of Step 2103) of supplying the liquid to only a part of an area on the substrate; a second step (part of Step 2103) of recovering at least a part of the liquid supplied in the first step and inspecting a state of the recovered liquid; a third step (Step 2105) of inspecting a state of a film of the substrate; and a fourth step (Steps 2104, 2106) of judging whether abnormality is present or absent in the substrate based on at least one of inspection results obtained in the second step and the third step.

According to the sixth aspect of the present invention, it is possible to easily judge whether or not the state of the substrate as the exposure objective or the state of the film of the substrate is adequate for the exposure based on the liquid immersion method, without actually performing the exposure.

According to a seventh aspect of the present invention, there is provided an exposure method for exposing a substrate (P) with an exposure light (EL) via an optical member (2) and a liquid (1), the exposure method comprising: filling a space between the optical member and an object with the liquid to form a liquid immersion space and recovering the liquid in the liquid immersion space; detecting information about the recovered liquid; and detecting information about abnormality of a liquid contact portion which comes into contact with the liquid, based on the detected information about the recovered liquid.

According to an eighth aspect of the present invention, there is provided an exposure apparatus (EX') which exposes a substrate (P) with an exposure light (EL) through a liquid (1), the exposure apparatus comprising: a liquid supply system (212, 212) which supplies the liquid (1) to only a part of an area on the substrate (P); a first detector (226) which detects a state of a liquid obtained by recovering the liquid supplied by the liquid supply system; a second detector (ALG) which detects a state of a film of the substrate; and a controller (CONT) which judges whether abnormality of the substrate is present or absent based on at least one of detection results obtained by the first detector and the second detector.

According to a ninth aspect of the present invention, there is provided an exposure apparatus which exposes a substrate (P) with an exposure light (EL) via an optical member (2) and a liquid (1), the exposure apparatus comprising: a liquid immersion mechanism (10, 20) which forms a liquid immersion space by filling a space between the optical member and an object with the liquid and which recovers the liquid in the liquid immersion space; a detecting device (226) which detects information about the recovered liquid; and a controller (CONT) which detects information about abnormality of a liquid contact portion which comes into contact with the liquid, based on the detected information about the recovered liquid.

According to a tenth aspect of the present invention, there is provided a method for producing a device, comprising: exposing (204) a substrate by using the exposure method or the exposure apparatus (EX, EX') of the present invention; developing (204) the exposed substrate; and processing (205) the developed substrate.

The parenthesized reference numerals, which are affixed to the predetermined elements of the present invention as defined above, correspond to the members depicted in the drawings to illustrate exemplary embodiments of the present invention. However, the respective reference numerals merely exemplify the elements of the present invention by way of example in order that the present invention is understood more easily, and do not limit the present invention to any construction of the embodiment.

### BRIEF DESCRIPTION OF THE DRAWINGS

Fig. 1 is a schematic construction view showing, with partial cutout, an example of an embodiment of an exposure apparatus of the present invention.
Fig. 2 shows a perspective view of a nozzle member 30 shown in Fig. 1.
Fig. 3 shows a perspective view of the nozzle member shown in Fig. 2 as seen from the lower surface.
Fig. 4 shows an exemplary construction of an alignment sensor ALG shown in Fig. 1.
Fig. 5 shows a plan view of a substrate stage PST and a measuring stage MST shown in Fig. 1.
Fig. 6 shows a sectional view of a state that a measuring table MTB, which is arranged in the measuring stage MST shown in Fig. 1, is moved to a position under or below a projection optical system PL.
Fig. 7 shows a plan view of examples of relative movement routes of a substrate holder PH, on the substrate stage PST shown in Fig. 1, relative to the projection optical system PL and the alignment sensor ALG.
Fig. 8 shows a flow chart of an exemplary sequence of an exposure method in a first embodiment of the present invention.
Fig. 9 shows a schematic construction view of an example of an exposure apparatus according to a second embodiment of the present invention.
Fig. 10 shows a perspective view of a nozzle member shown in Fig. 9.
Fig. 11 shows a plan view of an arrangement of supply ports and recovery ports for the liquid formed for a first member shown in Fig. 10.
Fig. 12 shows a sectional view taken along a line XII-XII shown in Fig. 10.
Fig. 13 shows a plan view of a substrate stage shown in Fig. 9 and a substrate on the substrate stage.
Fig. 14 shows a plan view of an area through which the liquid immersion area on the substrate is allowed to pass.
Fig. 15 shows a flow chart of an exemplary sequence, in the second embodiment of the present invention, for judging whether or not a film of the substrate is satisfactory.
Fig. 16 shows a flow chart of exemplary steps of producing a microdevice.

### Legend of reference numerals:

1: liquid, 2: optical element, 10: liquid supply mechanism, 11: liquid supply section, 13, 14: supply port, 20: liquid recovery mechanism, 21: liquid recovery section, 24: recovery port, 25: mesh filter, 26: cleaning liquid supply section, 30: nozzle member, 65: nozzle-observing device, 68A to 68G: observation objective portion, AR2: liquid immersion area, CONT: controller, EL: exposure light, M: mask, P: substrate, PL: projection optical system, ALG: alignment sensor, MST: measuring stage, MTB: measuring table.

### BEST MODE FOR CARRYING OUT THE INVENTION

### First Embodiment

A preferred example of the first embodiment of the present invention will be explained below with reference to the drawings.

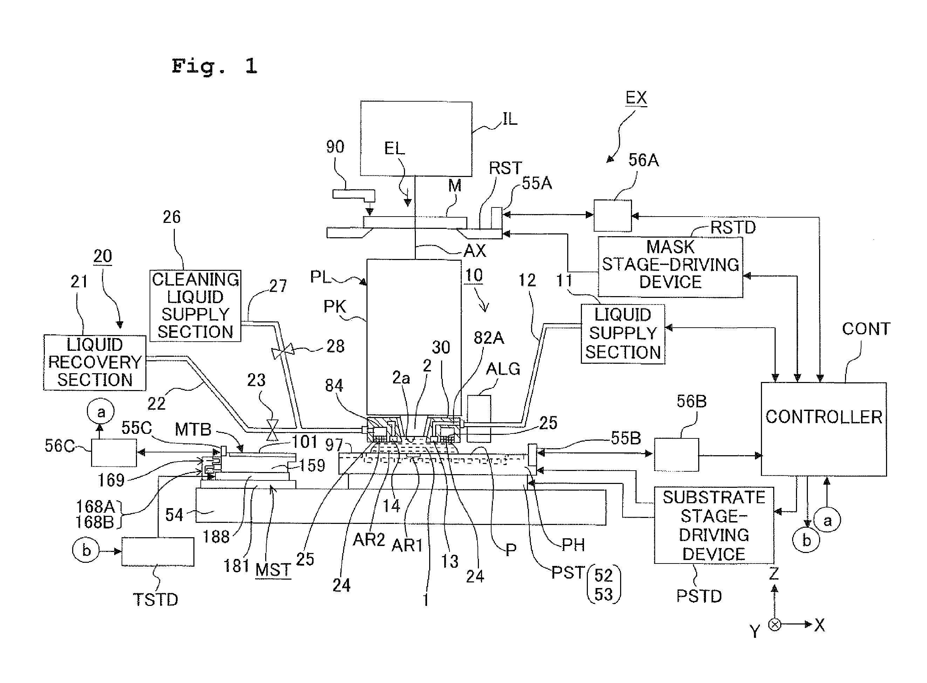

Fig. 1 shows a schematic construction of an exposure apparatus EX constructed of a scanning type exposure apparatus (so-called scanning stepper) according to this embodiment. With reference to Fig. 1, the exposure apparatus EX includes a mask stage RST which supports a mask M having a transferring pattern (pattern to be transferred) formed in the mask M; a substrate stage PST which supports a substrate P as an exposure objective; an illumination optical system IL which illuminates, with an exposure light EL, the mask M supported by the mask stage RST; a projection optical system PL which projects an image of the pattern (pattern image) of the mask M, illuminated with the exposure light EL, onto a projection area AR1 on the substrate P supported by the substrate stage PST; a measuring stage MST which has a reference mark for the alignment formed in the measuring stage MST; a controller CONT which integrally controls the operation of the entire exposure apparatus EX; a liquid immersion system (liquid immersion mechanism) which is provided for the application of the liquid immersion method; and an alignment sensor ALG which is provided to perform the alignment for the substrate P and which is based on the off-axis system and is, for example, the image processing system. The liquid immersion mechanism of this embodiment includes a liquid supply mechanism 10 which supplies the liquid 1 onto the substrate P and onto the measuring stage MST, and a liquid recovery mechanism 20 which recovers the liquid 1 supplied onto the substrate P and onto the measuring stage MST.

The exposure apparatus EX forms the liquid immersion area AR2 (locally) in a part of an area (partial area) on the substrate P including the projection area AR1 of the projection optical system PL or in the partial area on the substrate P and a surrounding area around the partial area, with the liquid 1 supplied from the liquid supply mechanism 10 at least during the period in which the pattern image of the mask M is transferred onto the substrate P. Specifically, the exposure apparatus EX adopts the local liquid immersion system wherein the space, which is between an optical element (for example, a lens having a substantially flat bottom surface or a plane-parallel) 2 arranged at the terminal end (end portion) on the side of the image plane (image plane side) of the projection optical system PL and a surface of the substrate P arranged on the image plane side, is filled with the liquid 1; and in which the substrate P is exposed with the exposure light EL passing through the mask M, via the projection optical system PL and the liquid 1 between the projection optical system PL and the substrate P, so that the pattern of the mask M is transferred to and exposed on the substrate P. In this embodiment, the liquid immersion exposure is performed by using a liquid immersion space-forming member (including, for example, a nozzle member 30) which forms the liquid immersion space including the optical path space for the exposure light EL irradiated from the projection optical system PL.

The following description will be made assuming that a Z axis extends in parallel to an optical axis AX of the projection optical system PL, an X axis extends in the synchronous movement direction (scanning direction) of the mask M and the substrate P in a plane perpendicular to the Z axis, and an Y axis extends in a direction (non-scanning direction) perpendicular to the scanning direction. The directions of rotation (inclination) about the X axis, the Y axis, and the Z axis are designated as the θX, θY, and θZ directions respectively. In this description, the term "substrate" includes those obtained by coating a base material including, for example, a semiconductor wafer such as a silicon wafer with a photosensitive material (hereinafter appropriately referred to as "resist"), and also includes those obtained by coating the base material with various films including a protective film (top coat film), etc., separately from the photosensitive film. The mask includes a reticle on which a device pattern to be subjected to the reduction projection onto the substrate is formed. For example, the mask is obtained such that a predetermined pattern is formed by using a light-shielding film such as chromium on a transparent plate member such as a glass plate. The transmission type mask is not limited to a binary mask in which the pattern is formed with the light-shielding film, and also includes, for example, a phase shift mask of the spatial frequency modulation type, the half tone type, etc. In this embodiment, those usable as the substrate P may be obtained, for example, such that a disc-shaped semiconductor wafer, which has a diameter of about 200 mm to 300 mm, is coated with the resist (photoresist) as the photosensitive material by an unillustrated coater/developer to provide a predetermined thickness (for example, about 200 nm), and a surface thereof is coated with an antireflection film or a top coat film, if necessary.

At first, the illumination optical system IL illuminates, with the exposure light EL, the mask M supported by the mask stage RST. The illumination optical system IL includes an optical integrator which uniformizes the illuminance of the light flux radiated from an unillustrated exposure light source; a condenser lens which collects the exposure light EL from the optical integrator; a relay lens system; a variable field diaphragm which defines the illumination area on the mask M brought about by the exposure light EL to have a slit-shaped form; and the like. A predetermined illumination area on the mask M is illuminated with the exposure light EL having the uniform illuminance distribution by the illumination optical system IL. Those used as the exposure light EL radiated from the illumination optical system IL include, for example, emission lines (i-ray, etc.) in the ultraviolet region radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the F₂ laser beam (wavelength: 157 nm). In this embodiment, the ArF excimer laser beam is used as the exposure light EL.

The mask stage RST supports the mask M. The mask stage RST is two-dimensionally movable in the plane perpendicular to the optical axis AX of the projection optical system PL on an unillustrated mask base, i.e., in the XY plane, and it is finely rotatable in the θZ direction. The mask stage RST is driven, for example, by a mask stage-driving device RSTD such as a linear motor. The mask stage-driving device RSTD is controlled by the controller CONT. A reflecting mirror 55A is provided on the mask stage RST. A laser interferometer 56A is provided at a position opposite to or facing the reflecting mirror 55A. In reality, the laser interferometer 56A constitutes a laser interferometer system having three or more length-measuring axes. The position in the two-dimensional direction and the angle of rotation of the mask stage RST (mask M) are measured in real-time by the laser interferometer 56A. An obtained result of the measurement is outputted to the controller CONT. The controller CONT drives the mask stage-driving device RSTD based on the result of the measurement to thereby move or position the mask M supported by the mask stage RST. The reflecting mirror 55A is not limited to only the plane mirror, and may include a corner cube (retroreflector). Alternatively, for example, it is also allowable to use a reflecting surface formed by mirror-finishing an end surface (side surface) of the mask stage RST, instead of the reflecting mirror 55A.

The projection optical system PL projects the pattern of the mask M onto the substrate P to perform the exposure at a predetermined projection magnification β (β represents the reduction magnification, which is, for example, 1/4, 1/5 or the like). The projection optical system PL is constructed by a plurality of optical elements including the optical element 2 which is provided at the terminal end on the side of the substrate P (image plane side of the projection optical system PL). The optical elements are supported by a barrel PK. The projection optical system PL is not limited to the reduction system, and may be any one of the 1x magnification system and the magnifying system. The optical element 2, which is disposed at the end portion of the projection optical system PL, is provided detachably (exchangeably) with respect to the barrel PK. The liquid 1 of the liquid immersion area AR2 comes into contact with the optical element 2. Although not shown, the projection optical system PL is provided on a barrel surface plate supported by three support columns via an anti-vibration mechanism. However, as disclosed, for example, in International Publication No. 2006/038952, the projection optical system PL may be supported in a hanging manner on an unillustrated main frame member which is arranged over or above the projection optical system PL, or on the mask base described above, etc.

In this embodiment, pure or purified water is used as the liquid 1. Not only the ArF excimer laser beam but also the far ultraviolet light beam (DUV light beam) such as the KrF excimer laser beam and the emission line radiated, for example, a mercury lamp is also transmissive through pure water. The optical element 2 is formed of calcium fluoride (CaF₂). Calcium fluoride has high affinity for water. Therefore, it is possible to allow the liquid 1 to make tight contact with the substantially entire surface of a liquid contact surface 2a of the optical element 2. The optical element 2 may be silica glass which has high affinity for water.

The resist of the substrate P is, as an example, a liquid-repellent resist which repels the liquid 1. As described above, the resist may be coated with the top coat for the protection, if necessary. In this embodiment, the property to repel the liquid 1 is called "liquid repellence". In a case that the liquid 1 is pure water, the liquid repellence means the water repellence. A substrate holder PH, which holds the substrate P, for example, by the vacuum attraction, is fixed to the upper portion of the substrate stage PST. The substrate stage PST is provided with a Z stage 52 which controls the position in the Z direction (focus position) and the angles of inclination in the θX and θY directions of the substrate holder PH (substrate P), and an XY stage 53 which is movable while supporting the Z stage 52. The XY stage 53 is placed over a guide surface (surface substantially parallel to the image plane of the projection optical system PL) which is parallel to the XY plane on the base 54, for example, with an air bearing (gas bearing) intervening therebetween. The substrate stage PST (Z stage 52 and XY stage 53) is driven by a substrate stage-driving device PSTD such as a linear motor. The substrate stage-driving device PSTD is controlled by the controller CONT. In this embodiment, the substrate holder is formed on a table which is movable in the Z, θX, and θY directions, and these components are collectively referred to as "substrate holder PH". The table and the substrate holder may be constructed separately or distinctly, and the substrate holder may be fixed to the table, for example, by the vacuum attraction. The Z stage 52 may be constructed, for example, by a substrate holder PH (table), and an actuator (for example, a voice coil motor) which drives the substrate holder PH (table) in the Z, θX, and θY directions.

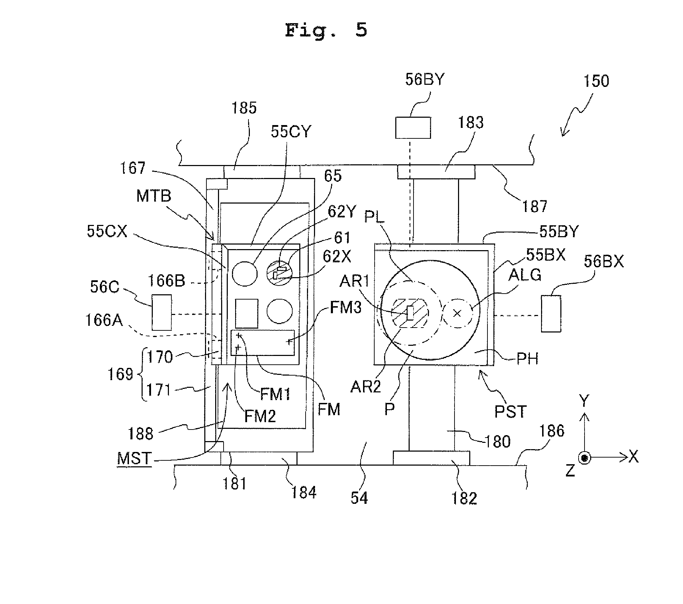

A reflecting mirror 55B is provided on the substrate holder PH on the substrate stage PST. A laser interferometer 56B is provided at a position opposite to or facing the reflecting mirror 55B. In reality, as shown in Fig. 5, the reflecting mirror 55B is constructed of an X axis reflecting mirror 55BX and a Y axis reflecting mirror 55BY. The laser interferometer 56B is also constructed of an X axis laser interferometer 56BX and a Y axis laser interferometer 56BY. With reference to Fig. 1 again, the position in the two-dimensional direction and the angle of rotation of the substrate holder PH (substrate P) on the substrate stage PST are measured in real-time by the laser interferometer 56B; and an obtained result of the measurement is outputted to the controller CONT. The controller CONT drives the substrate stage-driving device PSTD based on the result of the measurement to thereby move or position the substrate P supported by the substrate stage PST. The laser interferometer 56B may be capable of measuring also the information about the position in the Z axis direction and the rotation in the θX and θY directions of the substrate stage PST, and details thereof are disclosed, for example, in Published Japanese Translation of PCT International Publication for Patent Application No. 2001-510577 (corresponding to International Publication No. 1999/28790). A reflecting surface, which is formed by mirror-finishing a side surface of the substrate stage PST or the substrate holder PH, etc. may be used instead of the reflecting mirror 55B.

A plate 97 which is flat and annular and liquid-repellent, is provided exchangeably on the substrate holder PH so that the substrate P is surrounded with the plate 97. The liquid-repelling process includes, for example, a coating process with a thin film or films formed of a single layer or a plurality of layers using a material having the liquid repellence. The material having the liquid repellence includes, for example, fluorine-based resin materials such as polytetrafluoroethylene (Teflon (trade name)), acrylic resin materials, silicon-based resin materials, and synthetic resin materials such as polyethylene. The upper surface of the plate 97 is a flat surface which has an approximately same height as that of the surface of the substrate P held by the substrate holder PH. In this case, a gap of about 0.1 to 1 mm is provided between the edge of the substrate P and the plate 97. However, in this embodiment, the resist of the substrate P is liquid-repellent, and the liquid 1 has the surface tension. Therefore, the liquid 1 is hardly allowed to inflow into the gap. Even in a case that a portion, which is disposed in the vicinity of the circumferential edge of the substrate P, is exposed, it is possible to retain the liquid 1 between the plate 97 and the projection optical system PL. It is also allowable that the substrate holder PH is provided with a sucking device (not shown) in order that the liquid 1, which is allowed to inflow into the gap between the plate 97 and the substrate P, is discharged to the outside. Therefore, it is not necessarily indispensable that the resist (or the top coat) of the substrate P is liquid-repellent. In this embodiment, the plate 97 is provided for the substrate holder PH. However, the upper surface of the substrate holder PH, which surrounds the substrate P, may be subjected to the liquid-repelling process to form the flat surface.

### Liquid Supply and Recovery Mechanisms

Next, the liquid supply mechanism 10 shown in Fig. 1 is provided to supply a predetermined or certain liquid 1 onto the substrate P. The liquid supply mechanism 10 includes a liquid supply section 11 which is capable of feeding the liquid 1, and a supply tube 12 which has one end connected to the liquid supply section 11. The liquid supply section 11 is provided with a tank for accommodating the liquid 1, a filter section, a pressurizing pump, and the like. It is not necessarily indispensable that the liquid supply mechanism 10 is provided with all of the tank, the falter section, the pressurizing pump, etc.; and at least a part or parts thereof may be substituted, for example, with any equipment of the factory or the like in which the exposure apparatus EX is installed.

The liquid recovery mechanism 20 is provided to recover the liquid 1 supplied onto the substrate P. The liquid recovery mechanism 20 includes a liquid recovery section 21 which is capable of recovering the liquid 1, a recovery tube 22 which has one end connected to the liquid recovery section 21, a supply tube 27 which is connected to the recovery tube 22, and a cleaning liquid supply section 26 which is connected to an end of the supply tube 27 and which supplies a predetermined or certain cleaning liquid. Valves 23, 28 are provided at intermediate positions of the recovery tube 22 and the supply tube 27 respectively. The liquid recovery section 21 is provided with, for example, a vacuum system (sucking device) such as a vacuum pump, and a tank for accommodating the recovered liquid 1. The cleaning liquid supply section 26 is provided with a tank for accommodating the cleaning liquid, a pressurizing pump, etc. By closing the valve 23 disposed on the side of the recovery tube 22 and by opening the valve 28 disposed on the side of the supply tube 27, it is possible to supply the cleaning liquid from the cleaning liquid supply section 26 via the supply tube 27 to the recovery tube 22. It is not necessarily indispensable that the liquid recovery mechanism 20 is provided with all of the vacuum system, the tank, etc.; and at least a part or parts thereof may be substituted, for example, with any equipment of the factory or the like in which the exposure apparatus EX is installed.

Those usable as the cleaning liquid include a mixture liquid of thinner and water as the liquid distinct from the liquid 1, γ-butyrolactone; a solvent such as isopropyl alcohol (IPA); etc. However, it is also possible to use the liquid 1 itself as the cleaning liquid. The supply tube 27, which extends from the cleaning liquid supply section 26, can be also connected to the supply tube 12 which is communicated with the liquid supply section 11. In this case, the cleaning liquid may be supplied to the liquid immersion area (liquid immersion space) independently from the supply flow passage of the liquid 1 (for example, the supply tube 12). Further, for example, in a case that the liquid 1, which is supplied from the liquid supply section 11, is used as the cleaning liquid, it is not necessarily indispensable to provide the cleaning liquid supply section 26 and the supply tube 27.

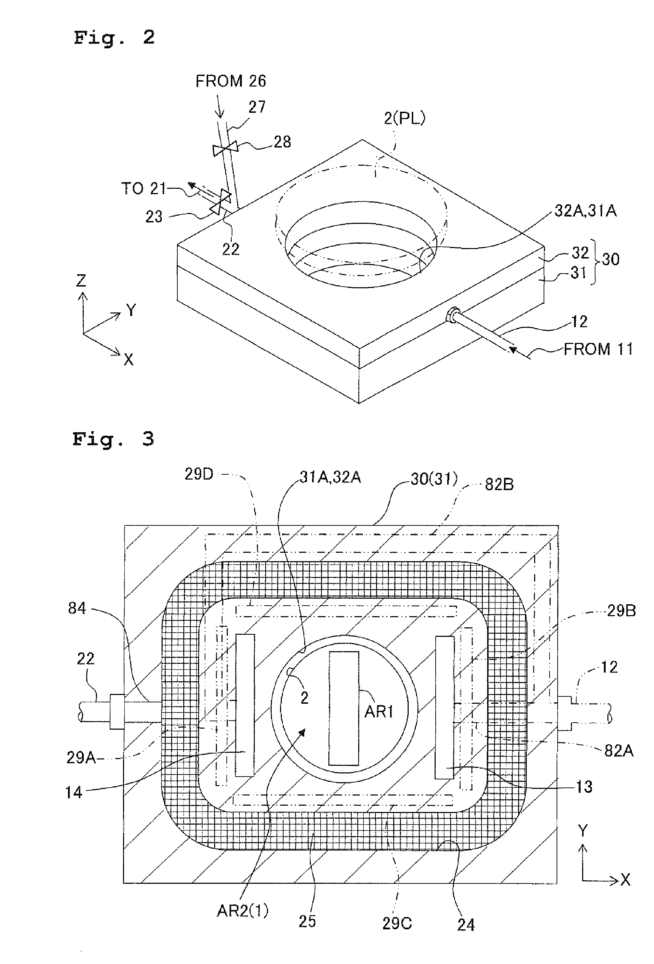

The nozzle member 30 is arranged as a flow passage-forming member in the vicinity of the optical element 2 disposed at the terminal end of the projection optical system PL. The nozzle member 30 is an annular member which is provided to surround the circumference of the optical element 2 at a position over or above the substrate P (substrate stage PST). The nozzle member 30 is supported by a column mechanism (not shown) via an unillustrated support member. The nozzle member 30 is provided with a first supply port 13 and a second supply port 14 (see Fig. 3) which are arranged opposite to or facing the surface of the substrate P in a state that the projection area AR1 of the projection optical system PL is located on the substrate P. The nozzle member 30 has supply flow passages 82A, 82B (see Fig. 3) disposed at the inside thereof. One end of the supply flow passage 82A is connected to the first supply port 13, and the second supply port 14 is connected via the supply flow passage 82B to an intermediate portion of the supply flow passage 82A (see Fig. 3). The other end of the supply flow passage 82A is connected to the liquid supply section 11 via the supply tube 12. Further, the nozzle member 30 is provided with a recovery port 24 (see Fig. 3) which has a rectangular frame-shaped form and which is arranged opposite to or facing the surface of the substrate P.

Fig. 2 is a perspective view schematically illustrating the nozzle member 30. As shown in Fig. 2, the nozzle member 30 is the annular member which is provided to surround the circumference of the optical element 2 disposed at the terminal end of the projection optical system PL. As an example, the nozzle member 30 is provided with a first member 31, and a second member 32 which is arranged on the upper portion of the first member 31. The first and second members 31, 32 are plate-shaped members respectively, and have through-holes 31A, 32A respectively which are disposed at central portions thereof and in which the projection optical system PL (optical element 2) can be arranged.

Fig. 3 is a perspective view illustrating the first member 31 disposed at the lower stage of the nozzle member 30 shown in Fig. 2 as seen from the bottom surface (lower surface). In Fig. 3, the supply flow passages 82A, 82B formed in the second member 32 disposed on the first member 31 and the supply tube 12 connected to the supply flow passage 82A are depicted by two-dot chain lines. The first member 31 of the nozzle member 30 is provided with the first supply port 13 which is formed on the side in the +X direction of the optical element 2 of the projection optical system PL and which supplies the liquid 1 onto the substrate P, and the second supply port 14 which is formed on the side in the -X direction of the optical element 2 and which supplies the liquid 1 onto the substrate P. The supply ports 13, 14 are arranged to interpose the projection area AR1 in the X direction (scanning direction of the substrate P). Each of the supply ports 13, 14 is a through-hole which penetrates through the first member 31 and which has a rectangular shape that is long in the Y direction. However, it is also allowable to adopt, for example, a circular arc-shaped form which is spread outwardly from the center of the projection area AR1.

Further, the first member 31 is formed with a frame-shaped recovery port 24 which is rectangular (or may be circular or the like) and which is arranged to surround the optical element 2 of the projection optical system PL (projection area AR1); and a recovery flow passage 84 which makes communication between the recovery port 24 and the recovery tube 22. The recovery port 24 is a groove-shaped recess formed on the bottom surface of the first member 31, and the recovery port 24 is provided on the outer side of the supply ports 13, 14 with respect to the optical element 2. A gap between the substrate P and the supply ports 13, 14 and a gap between the substrate P and the recovery port 24 are provided, as an example, substantially identically. A mesh filter 25, which is a porous member having a large number of small holes formed in a mesh form, is fitted to cover the recovery port 24. The liquid immersion area AR2, which is to be filled with the liquid 1, is formed inside an area which is rectangular (or may be circular or the like) and which is surrounded by the recovery port 24 to include the projection area AR1. Further, the liquid immersion area AR2 is formed locally on a part of the surface of the substrate P (or in a form to include a part of the surface of the substrate P) during the scanning exposure.

Each of the first member 31 and the second member 32 of the nozzle member 30 shown in Fig. 2 and the mesh filter 25 shown in Fig. 3 is formed of a liquid-attractive material which has relatively high affinity for the liquid 1, for example, stainless steel (SUS) or titanium. Therefore, with reference to Fig. 1, the liquid 1 in the liquid immersion area AR2 is allowed to pass through the mesh filter 25 of the recovery port 24 provided on the nozzle member 30, and then the liquid 1 is smoothly recovered by the liquid recovery section 21 via the recovery flow passage 84 and the recovery tube 22. In this process, any foreign matter which is included in the foreign matter such as the resist residue or the like and which is larger than the meshes of the mesh filter 25 remains on the surface of the mesh filter 25.

With reference to Fig. 3, the liquid recovery port 24 of this embodiment has the rectangular or circular frame-shaped form. However, instead of this construction, as depicted by two-dot chain lines, the following construction is also available. That is, it is allowable that the recovery port is constructed by using two recovery ports 29A, 29B which are rectangular (or may be circular arc-shaped, etc.) and which are arranged to interpose the supply ports 13, 14 in the X direction and two recovery ports 29C, 29D which are rectangular (or may be circular arc-shaped, etc.) and which are arranged to interpose the optical element 2 in the Y direction; and that the mesh filter is arranged on each of the recovery ports 29A to 29D. The number of the recovery ports 29A to 29D is arbitrary. For example, as disclosed in International Publication No. 2005/122218, the recovery ports 29A to 29D and the recovery port 24 may be used in a duplicate manner to recover the liquid 1 in the liquid immersion area AR2. Further, the mesh filter may be also arranged on each of the recovery ports 13, 14 in order to prevent any foreign matter in the liquid immersion area AR2 from entering into the inside of the nozzle member 30. On the contrary, for example, in a case that the possibility of the adhesion of the foreign matter to the inside of the recovery tube 22 is low, it is not necessarily indispensable to provide the mesh filter 25.

The nozzle member 30 used in the embodiment described above is not limited to the structure described above. It is also possible to use flow passage-forming members or the like described, for example, in European Patent Application Publication No. 1420298, International Publication Nos. 2004/055803, 2004/057589, and 2004/057590, and International Publication No. 2005/029559 (corresponding to United States Patent Application Publication No. 2006/0231206).

In this embodiment, the liquid supply ports 13, 14 and the recovery port 24 are provided on the same nozzle member 30. However, the supply ports 13, 14 and the recovery port 24 may be provided on distinct members. Further, with reference to Fig. 1, the supply ports 13, 14 may be communicated with different and distinct liquid supply sections, and the liquid 1 may be supplied from the supply ports 13, 14 to the liquid immersion area AR2 in a state that the supply amounts from the supply ports 13, 14 can be controlled independently from each other. It is also allowable that the supply ports 13, 14 are not arranged opposite to the substrate P. Further, the nozzle member 30 has the lower surface which is set to be arranged nearer to on the image plane side (substrate side) as compared with the lower end surface (light-exit surface) of the projection optical system PL. However, for example, the lower surface of the nozzle member 30 may be set at a height (Z position) same as that of the lower end surface of the projection optical system PL. A part (lower end portion) of the nozzle member 30 may be provided to extend crawlingly until arrival at a position under the projection optical system PL (optical element 2) so that the exposure light EL is not shielded or blocked.

As described above, the nozzle member 30 shown in Fig. 1 forms a part of the liquid supply mechanism 10 and a part of the liquid recovery mechanism 20. That is, the nozzle member 30 is a part of the liquid immersion mechanism of this embodiment. On the other hand, the valves 23, 28, which are provided for the recovery tube 22 and the supply tube 27, open/close the flow passages of the recovery tube 22 and the supply tube 27 respectively, and the operations of the valves 23, 28 are controlled by the controller CONT. The liquid recovery section 21 is capable of sucking and recovering the liquid 1 from the liquid immersion area AR2 via the recovery port 22 during a period in which the flow passage of the recovery tube 22 is open. When the flow passage of the recovery tube 22 is closed by the valve 23 in a state that the valve 28 is closed, the sucking recovery of the liquid 1 via the recovery port 24 is stopped. Afterwards, by opening the valve 28, it is possible to allow the cleaning liquid to flow through the recovery port 24 of the nozzle member 30 from the cleaning liquid supply section 26 via the supply tube 27, the recovery tube 22, and the mesh filter 25. A part or parts of the liquid immersion mechanism, for example, at least the nozzle member 30 may be supported in a hanging manner on the main frame (including the barrel surface plate described above) retaining or holding the projection optical system PL, or a part or parts of the liquid immersion mechanism may be provided on any frame member distinct from the main frame. Alternatively, in a case that the projection optical system PL is supported in the hanging manner as described above, the nozzle member 30 may be supported in a hanging manner integrally with the projection optical system PL. Alternatively, the nozzle member 30 may be provided on a measuring frame supported in a hanging manner independently from the projection optical system PL. In the case of the latter, it is also allowable that the projection optical system PL is not supported in the hanging manner.

With reference to Fig. 1, the liquid supply operations of the liquid supply section 11 and the cleaning liquid supply section 26 are controlled by the controller CONT. The controller CONT is capable of independently controlling the liquid supply amounts per section time to be supplied onto the substrate P by the liquid supply section 11 and the cleaning liquid supply section 26 respectively. The liquid 1, which is fed from the liquid supply section 11, is supplied onto the substrate P from the supply ports 13, 14 (see Fig. 3) provided on the lower surface of the nozzle member 30 (first member 31) to be opposite to the substrate P, via the supply tube 12 and the supply flow passages 82A, 82B of the nozzle member 30.

The liquid recovery operation of the liquid recovery section 21 is controlled by the controller CONT. The controller CONT is capable of controlling the liquid recovery amount per unit time to be recovered by the liquid recovery section 21. The liquid 1 on the substrate P, which is recovered via the mesh filter 25 from the recovery port 24 provided on the lower surface of the nozzle member 30 (first member 31) to be opposite to the substrate P, is recovered by the liquid recovery section 21 via the recovery tube 22 and the recovery flow passage 84 of the nozzle member 30.
Alignment Sensor ALG

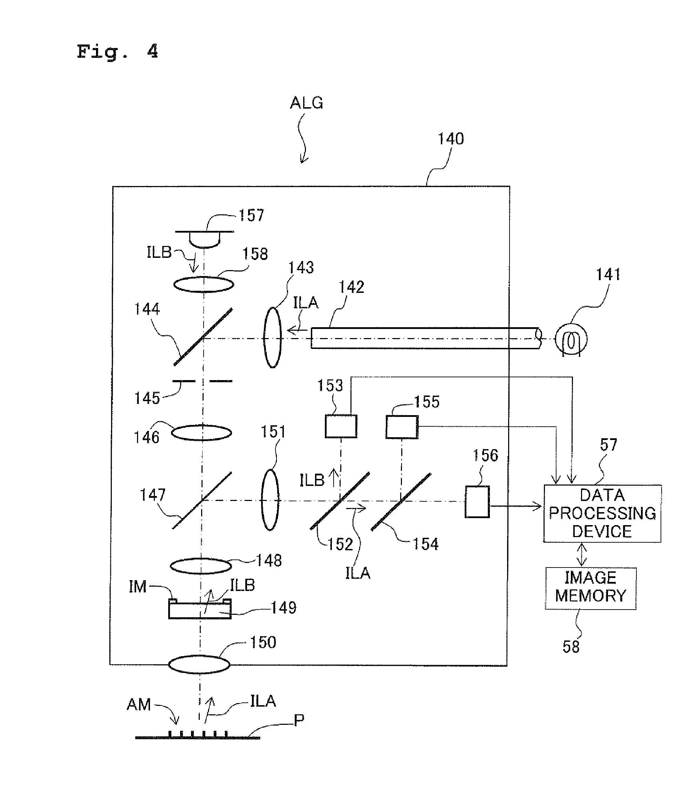

Next, an explanation will be made with reference to Fig. 4 about the construction of the alignment sensor ALG, of the image processing system, of this embodiment. The alignment sensor ALG is a FIA (Field Image Alignment) system of the off-axis system. The alignment sensor ALG is provided with a light source (for example, a halogen lamp) 141 which is disposed at the outside of a hermetically enclosed casing 140 for accommodating the optical system and which supplies an illumination light or illumination light beam having a wide wavelength band width (for example, about 400 to 800 nm). The illumination light, which is supplied from the light source 141, is guided into the casing 140 via a light-collecting optical system (not shown) and a light guide 142 which is constructed of an optical fiber. An illumination light ILA, which is approximately in the visible region and which is irradiated or which exits from the light-exit end of the light guide 142, comes via a condenser lens 143 into a dichroic mirror 144 which reflects the visible light and through which the infrared light is transmitted. An illumination light ILA reflected by the dichroic mirror 144 comes into a prism 147 via an illumination field diaphragm 145 and a lens system 146.

The prism 147 has such a property that the light coming from the upper position is totally transmitted and the light coming from the lower position is totally reflected. The illumination light ILA is transmitted through the prism 147, and then the illumination light ILA comes into an infrared reflecting plate 149 via a lens system 148. The infrared reflecting plate 149 is a light-transmissive substrate having an index mark IM which is formed on its surface and an infrared reflective film which is formed on its back surface and which has such a characteristic that the infrared light is reflected and the visible light is transmitted. The illumination light ILA transmitted through the infrared reflecting plate 149 illuminates an alignment mark AM (or a reference mark, etc.) formed on the substrate P, via an objective lens 150.

The reflected light or light beam (including the diffracted light or light beam; referred to as "ILA" as well), from the alignment mark AM (or from the reference mark, etc.) by being irradiated with the illumination light ILA, is transmitted through the objective lens 150, the infrared reflecting plate 149, and the lens system 148, and the reflected light is totally reflected by the prism 147. After that, the reflected light comes, via the lens system 151, into the dichroic mirror 152 through which the visible light is transmitted and which reflects the infrared light. The reflected light ILA transmitted through the dichroic mirror 152 comes into a half prism 154 for the XY branching via an unillustrated condenser lens. The light reflected by the half prism 154 forms a mark image on CCD 155 which serves as an image pickup element for the X direction. The light transmitted through the half prism 154 forms a mark image on CCD 156 which serves as an image pickup element for the Y direction.

The alignment sensor ALG is provided with an LED (light emitting diode) 157 which emits an illumination light having a wavelength of, for example, 870 nm as a light source for illuminating an index mark IM. The illumination light ILB in the infrared region, which is radiated from the LED 157, illuminates the infrared reflecting plate 149 via the condenser lens 158, the dichroic mirror 144, the illumination field diaphragm 145, the lens system 146, the prism 147, and the lens system 148. The illumination light ILB, reflected by the infrared reflecting surface of the infrared reflecting plate 149, illuminates the index mark IM formed on the upper surface of the infrared reflecting plate 149. The illumination light ILB, which illuminates the index mark IM, is allowed to pass through the lens system 148, the prism 147, and the lens system 151, and then the illumination light ILB is reflected by the dichroic mirror 152 to form an image of the index mark IM on the CCD 153 as an image pickup element for the index mark.

Each of the CCD's 155, 156 for the X direction and the Y direction is provided with a large number of pixels arranged two-dimensionally in a long area thereon corresponding to the X direction and the Y direction on the substrate stage PST shown in Fig. 1. Each of the CCD's 155, 156 is used to detect the position of the alignment mark (or the reference mark) for the X axis and the Y axis. The CCD 153 for the index mark is provided with a large number of pixels arranged two-dimensionally, for example, in a frame-shaped area corresponding to the image of the index mark IM. The CCD 153 is used to detect the position of the index mark IM to serve as the position reference in the X direction and the Y direction upon detecting the position of the alignment mark or the reference mark. The image pickup signals of CCD's 155, 156, 153 are supplied to a data processing device 57. Upon detecting the mark, the data processing device 57 detects, from the supplied image pickup signal, the amounts of deviation or shift in the X direction and the Y direction of the detection objective mark with respect to the index mark IM. A result of the detection is fed to an alignment control section in the controller CONT shown in Fig. 1.

As described above, the alignment sensor ALG is used to detect the position of the detection objective mark. However, in this embodiment, as described later on, the image data of the image of the detection objective portion, which is photographed or imaged by the alignment sensor ALG, is used to judge whether or not any abnormality is present in at least a part (observation objective portion) of the liquid contact portion as the portion which is included in the member constructing the exposure apparatus EX and which has the possibility to come into contact with the liquid 1 when the exposure is performed by the liquid immersion method. That is, the alignment sensor ALG is also used as the device for optically observing the state of the observation objective portion. Any one of the CCD's 155, 156 for the X direction and the Y direction may be used as the image pickup element for this purpose. The resolution of the alignment sensor ALG upon the abnormality judgment (size of the object on the object plane corresponding to one pixel of CCD 155 (or 156)) may be, for example, several 10 µm. However, the resolution upon the alignment is considerably finer than the above, which causes no problem.

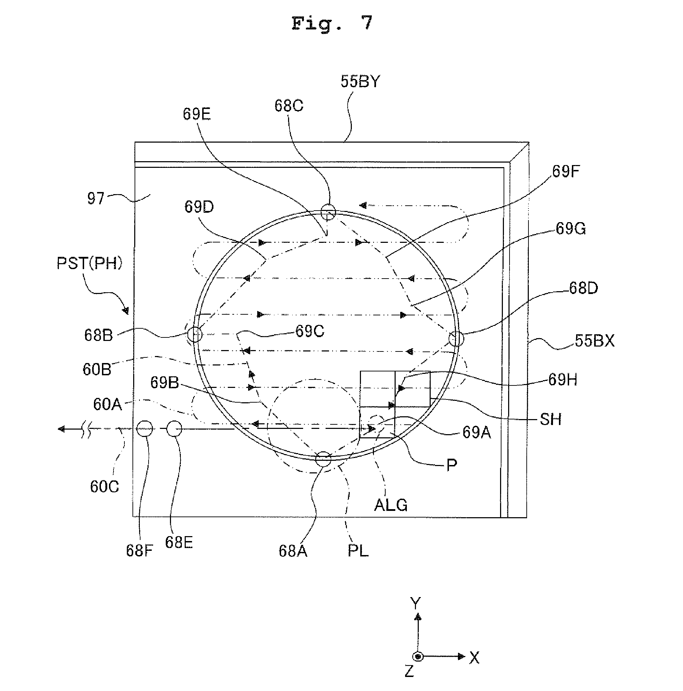

In this procedure, the image data, which is photographed for the abnormality judgment, is stored in an image memory 58 constructed of a magnetic disk device connected to the data processing device 57, etc. The field of the alignment sensor ALG is in the -Z direction. Therefore, the liquid contact portion, for which the abnormality judgment is performed by the alignment sensor ALG, includes the upper surface of the plate 97 on the substrate holder PH (substrate stage PST), the area between the plate 97 and the substrate P, the upper surface of the substrate P, and the upper surface of the measuring stage MST (upper surface of a plate 101 described later on). In a case that a part of the sucking device for sucking the liquid allowed to inflow into the groove between the plate 97 and the substrate P is provided in the substrate holder PH, the interior of the groove (portion at which the sucking port is formed) is also the liquid contact portion in the interior of which the foreign matter easily remains in some cases. Accordingly, as shown in Fig. 7, for example, areas, which include a plurality of (for example, four) areas arranged at equal angular intervals and which are included in the area between the plate 97 and the substrate P, may be designated as observation objective portions 68A, 68B, 68C, 68D to be observed by the alignment sensor ALG.

In this embodiment, as shown in Fig. 1, an alignment sensor 90 of the image processing system (mask alignment system) (for example, so-called reticle alignment microscope), which is provided to detect the positions of the alignment mark on the mask M and the predetermined reference mark on the measuring stage MST corresponding to the alignment mark, is arranged over or above the mask stage RST. The alignment sensor 90 is capable of observing the image of an object (foreign matter, etc.) on the image plane of the projection optical system PL via the projection optical system PL. Accordingly, the alignment sensor 90 on the side of the mask can be also used to judge the abnormality of the liquid contact portion. Distinctly from the alignment sensors ALG, 90, for example, an observing device such as a spectrometer (for example, a device for radiating the wide band illumination light onto the detection objective portion to measure the distribution of the reflectance while being classified by the wavelength) may be arranged in the vicinity of the side surface of the projection optical system PL to detect the change of the observation objective portion in the liquid contact portion (change of the reflectance distribution corresponding to the presence or absence of the foreign matter, etc.) by the spectrometer.

In a case that the ultraviolet pulsed light of the excimer laser is used as the exposure light EL as in this embodiment, for example, some foreign matters such as the resist residues may emit the fluorescence (including the phosphorescence in this specification) by being irradiated with the pulsed light. Accordingly, the alignment sensor ALG (or the alignment sensor 90) of this embodiment is used also as an fluorescence microscope for detecting the image brought about by the fluorescence emitted by the foreign matter as described above, if necessary. In this case, for example, a fluorescence filter, through which only the fluorescence as the detection objective is transmissive, may be previously provided insertably or detachably at the light-incident surface of the CCD 155 or 156 for the observation shown in Fig. 4. When the alignment sensor ALG is used as the fluorescence microscope, the fluorescence filter may be arranged on the light-incident surface of the CCD 155 or 156. In this embodiment, each of the alignment sensors (mark-detecting systems) ALG, 90 is of the image processing system. However, there is no limitation to this. It is also allowable to adopt any other system, for example, a system which detects the diffracted light emitted from the mark by being irradiated with a coherent beam. The optical device for detecting the state of the liquid contact portion is not limited to the alignment sensors ALG, 90, the spectrometer, and the fluorescence microscope. For example, it is also allowable to use a detecting system which detects the scattered light emitted from the liquid contact portion (the foreign matter, etc.).

### Measuring Stage

With reference to Fig. 1, the measuring stage MST includes an X stage 181 which has an oblong shape long in the Y direction and which is driven in the X direction (scanning direction), a leveling table 188 which is placed thereon, for example, with an air bearing intervening therebetween, and a measuring table MTB which serves as a measuring unit arranged on the leveling table 188. As an example, the measuring table MTB is placed on the leveling table 188 with an air bearing intervening therebetween. However, the measuring table MTB and the leveling table 188 can be integrated into one body as well. The X stage 181 is placed on the base 54 movably in the X direction, for example, with an air bearing intervening therebetween.

Fig. 5 is a plan view illustrating the substrate stage PST and the measuring stage MST shown in Fig. 1. With reference to Fig. 5, X axis stators 186, 187, each of which includes a plurality of permanent magnets arranged in a predetermined arrangement in the X direction on the inner surface, are installed in parallel to the X axis so as to interpose the base 54 in the Y direction (non-scanning direction) between the X axis stators 186, 187. A Y axis slider 180 is arranged movably in the X direction substantially in parallel to the Y axis, between the stators 186, 187 via movers 182, 183 which include coils respectively. The substrate stage PST is arranged movably in the Y direction along the Y axis slider 180. A Y axis linear motor, which drives the substrate stage PST in the Y direction, is constructed by movers included in the substrate stage PST and stators (not shown) on the Y axis slider 180. A pair of X axis linear motors, which derive the substrate stage PST in the X direction, are constructed by the movers 182, 183 and the stators 186, 187 corresponding thereto respectively. The X axis and Y axis linear motors, etc. correspond to the substrate stage-driving device PSTD shown in Fig. 1.

On the other hand, an X stage 181 of the measuring stage MST is arranged movably in the X direction, between stators 186, 187 via movers 184, 185 including coils respectively. A pair of X axis linear motors, which drive the measuring stage MST in the X direction, are constructed by the movers 184, 185 and the stators 186, 187 corresponding thereto respectively. The X axis linear motors, etc. are represented by the measuring stage-driving device TSTD in Fig. 1.

With reference to Fig. 5, a stator 167 which has a "]"-shaped cross-sectional form and in which a plurality of permanent magnets are arranged to generate uniform magnetic field in the Z direction, to be opposite to or facing the inner surface and a stator 171 which has a flat plate-shaped form and which includes a coil wound (arranged) substantially along the X axis are successively fixed to an end of the X stage 181 in the -X direction so that the stators 167, 171 are disposed substantially in parallel to the Y axis and are stacked in the Z direction. Movers 166A, 166B, which include coils wound (arranged) along the Y axis respectively, are fixed at two positions respectively, the two positions being separated in the Y direction on the measuring table MTB so that the movers 166A, 166B are arranged in the stator 167 disposed at the lower position. A mover 170, which has a "]"-shaped cross-sectional form and in which a plurality of permanent magnets are arranged in a predetermined arrangement in the Y direction, is fixed to the measuring table MTB so that the stator 171 disposed at the upper position is interposed in the Z direction. X axis voice coil motors 168A, 168B (see Fig. 1), which drive the measuring table MTB in the X direction and the θZ direction by minute amounts with respect to the X stage 181 respectively, are constructed by the movers 166A, 166B and the stator 167 disposed at the lower position. A Y axis linear motor 169, which drives the measuring table MTB in the Y direction with respect to the X stage portion 181, is constructed by the mover 170 and the stator 171 disposed at the upper position.

An X axis reflecting mirror 55CX and a Y axis reflecting mirror 55CY are fixed in the -X direction and the +Y direction respectively on the measuring table MTB. An X axis laser interferometer 56C is arranged to be opposite to or facing the reflecting mirror 55CX in the -X direction. The reflecting mirrors 55CX, 55CY are represented by the reflecting mirror 55C in Fig. 1. The laser interferometer 56C is a multi-axis laser interferometer. The position in the X direction, the angle of rogation in the θZ direction, etc. of the measuring table MTB are always measured by the laser interferometer 56C. For example, a reflecting surface, which is formed by mirror-finishing a side surface of the measuring stage MST, etc. may be used instead of the reflecting mirrors 55CX, 55CY.

On the other hand, with reference to Fig. 5, the laser interferometer 56BY, which is provided to measure the position in the Y direction, is commonly used for the substrate stage PST and the measuring stage MST. That is, the optical axes of the two X axis laser interferometers 56BX, 56C pass through the center of the projection area AR1 of the projection optical system PL (coincident with the optical axis AX shown in Fig. 1 in this embodiment), and the optical axes are parallel to the X axis. The optical axis of the Y axis laser interferometer 56BY passes through the center of the projection area (optical axis AX), and the optical axis is parallel to the Y axis. Therefore, usually, when the substrate stage PST is moved to the position under or below the projection optical system PL in order to perform the scanning exposure, then the laser beam of the laser interferometer 56BY is irradiated onto the reflecting mirror 55BY of the substrate stage PST, and the position of the substrate stage PST (substrate P) in the Y direction is measured by the laser interferometer 56BY. When the measuring table MTB of the measuring stage MST is moved to the position under or below the projection optical system PL in order to measure the image formation characteristic of the projection optical system PL, etc., then the laser beam of the laser interferometer 56BY is irradiated onto the reflecting mirror 55CY of the measuring table MTB, and the position of the measuring table MTB in the Y direction is measured by the laser interferometer 56BY. Accordingly, the positions of the substrate stage PST and the measuring table MTB can be always measured highly accurately, with the center of the projection area of the projection optical system PL as a reference. Further, it is possible to decrease the number of laser interferometers which are highly accurate but expensive, thereby making it possible to reduce the production cost.

Linear encoders (not shown) of the optical system, etc. are arranged along the Y axis linear motor for the substrate stage PST and the Y axis linear motor 169 for the measuring table MTB. The position in the Y direction of the substrate stage PST or the measuring table MTB is measured by each of the linear encoders during a period in which the laser beam of the laser interferometer 56BY is not irradiated onto the reflecting mirror 55BY or 55CY.

With reference to Fig. 1 again, the position in the two-dimensional direction and the angle of rotation of the measuring table MTB are measured by the laser interferometer 56C and the laser interferometer 56BY shown in Fig. 5 (or the linear encoder). An obtained result of the measurement is outputted to the controller CONT. The controller CONT drives the measuring stage-driving device TSTD, the linear motor 169, and the voice coil motors 168A, 168B based on the measurement result to thereby move or position the measuring table MTB of the measuring stage MST.

The leveling table 188 is provided with three Z axis actuators each of which is capable of controlling the position in the Z direction, for example, in accordance with an air cylinder or voice coil motor system. Usually, the position in the Z direction and the angles in the θX direction and the θY direction of the measuring table MTB are controlled by the leveling table 188 so that the upper surface of the measuring table MTB is focused with respect to the image plane of the projection optical system PL. For this purpose, an autofocus sensor (not shown) is provided in the vicinity of the nozzle member 30 in order to measure the position of a detection objective surface such as the upper surface of the substrate P disposed in the projection area AR1 and in the vicinity of the projection area AR1. The controller CONT controls the operation of the leveling table 188 based on the measured value obtained by the autofocus sensor. Further, although not shown, an actuator is also provided in order that the position of the leveling table 188 in the X direction, the Y direction, and the θZ direction with respect to the X stage 181 is maintained at a predetermined position.

The autofocus sensor also detects the information about the inclination in the θX and θY directions (angle of rotation) by measuring the position information in the Z direction about the detection objective surface at a plurality of measuring points thereof respectively. At least a part or parts of the plurality of measuring points may be defined in the liquid immersion area AR2 (or in the projection area AR1). Alternatively, all of the plurality of measuring points may be defined outside the liquid immersion area AR2. Further, for example, when the laser interferometers 56B, 56C are capable of measuring the position information in the Z axis, θX, and θY directions about the detection objective surface, then it is also allowable that the autofocus sensor is not provided for the purpose of making it possible to measure the position information in the Z direction during the exposure operation of the substrate P. It is also allowable that the position of the detection objective surface is controlled in relation to the Z axis, θX, and θY directions by using the measurement results of the laser interferometers 55B, 55C at least during the exposure operation.

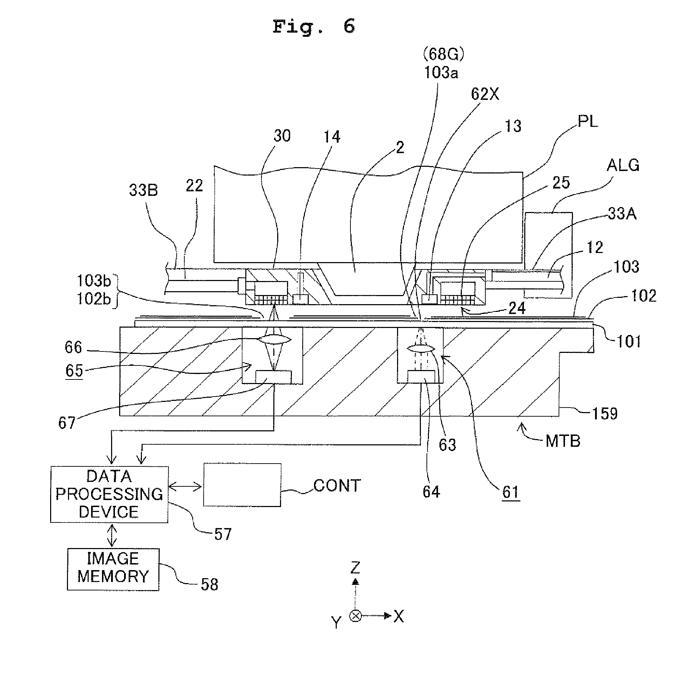

The measuring table MTB of this embodiment is provided with measuring devices (measuring members) for performing various types of measurement in relation to the exposure. That is, the measuring table MTB is provided with a body 159 of the measuring table (measuring-table body 159) to which the reflecting mirror 55C, the mover of the linear motor 169, etc. are fixed; and a plate 101 which is fixed to the upper surface of the measuring-table body 159 and which is formed of a light-transmissive material having a low coefficient of expansion including, for example, silica glass. A light-shielding film 102 (see Fig. 6), which is formed of a chromium film, is formed on the substantially entire surface of the plate 101; and the plate 101 has, at a several positions of the plate 101, an area for the measuring device and a reference mark area FM having a plurality of reference marks formed therein, as disclosed in Japanese Patent Application Laid-open No. 5-21314 (corresponding to United States Patent No. 5,243,195), etc.

As shown in Fig. 5, a pair of reference marks FM1, FM2 for the alignment sensor 90 for the mask shown in Fig. 1 and a reference mark FM3 for the alignment sensor ALG for the substrate are formed in the reference mark area FM on the plate 101. By measuring the positions of the reference marks by the corresponding alignment sensors respectively, it is possible to measure the baseline amount as the spacing distance (positional relationship) between the projection position of the projection area AR1 of the projection optical system PL and the detecting position of the alignment sensor ALG. Upon measuring the baseline amount, the liquid immersion area AR2 is formed also on the plate 101.

Various types of measuring aperture patterns are formed in the area for the measuring devices on the plate 101. The measuring aperture patterns include, for example, an aperture pattern for measuring the spatial image (for example, slit-shaped aperture pattern 62X, 62Y), a pinhole aperture pattern for measuring the uneven illuminance, an aperture pattern for measuring the illuminance, and an aperture pattern for measuring the wave aberration. Measuring devices, which correspond to the aperture patterns respectively and each of which is constructed of a measuring optical system and a photoelectric sensor, are arranged in the measuring-table body 159 located on the bottom surface side of the aperture patterns.

Examples of the measuring devices include, for example, an uneven illuminance sensor as disclosed, for example, in Japanese Patent Application Laid-open No. 57-117238 (corresponding to United States Patent No. 4,465,368), a spatial image-measuring device 61 for measuring the light intensity of the spatial image (projected image) of the pattern projected by the projection optical system PL as disclosed, for example, in Japanese Patent Application Laid-open No. 2002-14005 (corresponding to United States Patent Application Publication No. 2002/0041377), an illuminance monitor as disclosed, for example, in Japanese Patent Application Laid-open No. 11-16816 (corresponding to United States Patent Application Publication No. 2002/0061469), and a wave aberration-measuring device as disclosed, for example, in International Publication No. 99/60361 (corresponding to European Patent No. 1,079,223).

In this embodiment, corresponding to that the liquid immersion exposure is performed to expose the substrate P with the exposure light EL via the projection optical system PL and the liquid 1, the exposure light EL is received via the projection optical system PL and the liquid 1 in the uneven illuminance sensor, the illuminance monitor, the spatial image-measuring device, the wave aberration-measuring device described above, etc. to be used for the measurement using the exposure light EL. Therefore, a liquid-repellent coat 103 (see Fig. 6) is applied to the light-shielding film 102 disposed on the surface of the plate 101, except for a specified area as described later on.

With reference to Fig. 5, a nozzle-observing device 65 is provided on the measuring table MTB in order to optically observe mainly the states of the optical element 2 and the nozzle member 30 shown in Fig. 1.
Fig. 6 is a sectional view illustrating such a state that the measuring table MTB shown in Fig. 5 is moved to a position on the bottom surface side of the projection optical system PL. With reference to Fig. 6, the spatial image-measuring device 61, which includes a light-collecting lens 63 and a photoelectric detector 64, is arranged in the measuring-table body 159 disposed on the bottom surface side of the X axis aperture pattern 62X. A photoelectric conversion signal of the photoelectric detector 64 is supplied to the data processing device 57. In this case, the substantially entire upper surface of the liquid-repellent coat 103 is the liquid contact portion which has the possibility to come into contact with the liquid for the liquid immersion exposure.

However, the liquid-repellent coat 103 is removed from a substantially circular area 103a which includes the aperture pattern 62X provided for the light-shielding film 102 (and the Y axis aperture pattern 62Y shown in Fig. 5) so that the exposure light EL is allowed to pass therethrough. However, the circular area 103a is also the liquid contact portion. Therefore, in a case that the liquid 1 shown in Fig. 1 is supplied to the circular area 103a to provide the liquid immersion area AR2 in order to measure the image formation characteristic of the projection optical system PL by using the spatial image-measuring device 61, if any foreign matter enters into and mixes with the liquid 1, then there is such a possibility that the foreign matter might easily remain especially in the vicinity of the aperture pattern 62X, etc. Accordingly, in this embodiment, the inside of the circular area 103 included in the liquid contact portion, from which the liquid-repellent coat is removed, is designated as one observation objective portion 68G for the abnormality judgment by the alignment sensor ALG shown in Fig. 1.

With reference to Fig. 6, an opening 102b is provided for the light-shielding film 102, and the liquid-repellent coat 103 is removed from a substantially circular area 103b which includes the opening 102b so that the exposure light EL is allowed to pass therethrough. The nozzle-observing device 65, which includes an objective lens 66 and a two-dimensional image pickup device 67 constructed of two-dimensional CCD, is arranged on the bottom surface of the opening 102b in the measuring-table body 159. An image pickup signal of the image pickup device 67 is supplied to the data processing device 57. An image data obtained from the image pickup signal is stored in the image memory 58. The resolution of the nozzle-observing device 65 (size of the object on the object plane corresponding to one pixel of the image pickup device 67) is set to be smaller than, for example, about several 10 µm.

The liquid contact portion, which is the observation objective to be observed by the nozzle-observing device 65, includes the bottom surface of the nozzle member 30, the inner portions of the supply ports 13, 14, the inner portion of the recovery port 24 (including the mesh filter 25), and the bottom surface of the optical element 2. In particular, it is feared that the foreign matter might adhere to the mesh filter 25. Therefore, as an example, the bottom surface of the mesh filter 25 is the observation objective portion to be observed by the nozzle-observing device 65. Accordingly, in Fig. 6, the object plane of the objective lens 66 of the nozzle-observing device 65 is set for the bottom surface of the mesh filter 25. The nozzle-observing device 65 is also provided with an illumination system (not shown) in order to illuminate the detection objective.

In this embodiment, at least one of the plurality of measuring devices, the reference mark, and the nozzle-observing device 65 are provided as the measuring members on the measuring table MTB. However, the type and/or the number of the measuring members, etc. are not limited to this. For example, a transmittance-measuring device, which measures the transmittance of the projection optical system PL, may be provided as the measuring member. Only a part or parts of the measuring device or the nozzle-observing device 65 may be provided on the measuring stage MST, and the remaining portion may be provided outside the measuring stage MST. Any member different from the measuring member, for example, a cleaning member for cleaning the nozzle member 30, the optical element 2, etc. may be provided on the measuring stage MST. A cleaning device, which has a jet nozzle for jetting, for example, the liquid 1 or the cleaning liquid to the nozzle member 30 or the like, may be used as the cleaning member. It is also allowable that the measuring member, the cleaning member and the like are not provided on the measuring stage MST. In this case, the measuring stage MST is arranged opposite to the projection optical system PL while being exchanged with the substrate stage PST in order to maintain the liquid immersion area AR2 described above, for example, when the substrate P is exchanged. At least one measuring member may be provided on the substrate stage PST.

### Exposure Step

As shown in Fig. 7, a plurality of shot areas SH are comparted (defined) on the substrate P. For the purpose of convenience of the explanation, only a part of the shot areas SH are shown in Fig. 7. In the exposure apparatus EX shown in Fig. 1, the controller CONT moves the substrate stage PST while monitoring the output of the laser interferometer 56B so that the substrate P is advanced along with a predetermined route with respect to the optical axis AX (projection area AR1) of the projection optical system PL, and successively exposes the plurality of shot areas in the step-and-scan manner. That is, a part of the pattern image of the mask M is projected onto the rectangular projection area AR1 by the projection optical system PL during the scanning exposure effected by the exposure apparatus EX. The mask M is moved at a velocity V in the X direction with respect to the projection optical system PL, in synchronization with which the substrate P is moved at a velocity β•V (β represents the projection magnification) via the substrate stage PST. After the completion of the exposure of one shot area on the substrate P, another shot area to be exposed next is moved to the scanning start position by the step-movement of the substrate P. The scanning exposure process is successively performed for the respective shot areas thereafter while moving the substrate P in the step-and-scan manner.

The controller CONT drives the liquid supply mechanism 10 during the exposure process for the substrate P to perform the liquid supply operation for supplying the liquid onto the substrate P. The liquid 1, fed from the liquid supply section 11 of the liquid supply mechanism 10, flows through the supply tube 12, and then the liquid 1 is supplied onto the substrate P via the supply flow passages 82A, 82B formed in the nozzle member 30. The liquid 1 supplied onto the substrate P flows under or below the projection optical system PL in conformity with the movement of the substrate P. For example, when the substrate P is moved in the +X direction during the exposure of a certain shot area, the liquid 1 flows under or below the projection optical system PL at a velocity which is approximately same as that of the substrate P in the +X direction which is the same as the direction of the substrate P. In this state, the exposure light EL, radiated from the illumination optical system IL and passing through the mask M, is irradiated onto the image plane side of the projection optical system PL, thereby exposing the substrate P with the pattern of the mask M via the projection optical system PL and the liquid 1 of the liquid immersion area AR2. The controller CONT performs the supply of the liquid 1 onto the substrate P by the liquid supply mechanism 10 when the exposure light EL is radiated onto the image plane side of the projection optical system PL, i.e., during the exposure operation for the substrate P. The liquid immersion area AR2 is formed satisfactorily by continuing the supply of the liquid 1 by the liquid supply mechanism 10 during the exposure operation. On the other hand, the controller CONT performs the recovery of the liquid 1 on the substrate P by the liquid recovery mechanism 20 when the exposure light EL is radiated onto the image plane side of the projection optical system PL, i.e., during the exposure operation for the substrate P. It is possible to suppress the expansion of the liquid immersion area AR2 by continuously executing the recovery of the liquid 1 by the liquid recovery mechanism 20 during the exposure operation (when the exposure light EL is radiated onto the image plane side of the projection optical system PL).

In this embodiment, the liquid supply mechanism 10 supplies the liquid 1 onto the substrate P simultaneously from the both sides of the projection area AR1 through the supply ports 13, 14 during the exposure operation. Accordingly, the liquid 1, supplied from the supply ports 13, 14 onto the substrate P, is satisfactorily spread in the space between the substrate P and the lower end surface of the optical element 2 disposed at the terminal end of the projection optical system PL and the space between the substrate P and the lower surface of the nozzle member 30 (first member 31). The liquid immersion area AR2 is formed in a range which is wider than at least the projection area AR1. If the supply ports 13, 14 are connected to distinct liquid supply sections, the liquid supply amount per unit time, which is to be supplied from a position approaching the projection area AR1 in relation to the scanning direction, may be set to be greater than the liquid supply amount which is to be supplied from a position on the side opposite to the position approaching to the projection area AR1.

It is also allowable that the recovery operation for recovering the liquid 1 by the liquid recovery mechanism 20 is not performed during the exposure operation, and that the flow passage of the recovery tube 22 is opened after the completion of the exposure to recover the liquid 1 on the substrate P. As an example, after the completion of the exposure for a certain shot area on the substrate P, the liquid 1 on the substrate P may be recovered by the liquid recovery section 21 only during a partial period (at least a part of the stepping movement period of the substrate P) until the start of the exposure for another shot area to be exposed next to the certain shot area.

The controller CONT continues the supply of the liquid 1 by the liquid supply mechanism 10 during the exposure of the substrate P. By continuing the supply of the liquid 1 as described above, it is possible not only to fill the space between the projection optical system PL and the substrate P with the liquid 1 satisfactorily, but also to avoid the generation of the vibration of the liquid 1 (so-called the water hammer phenomenon). In this way, all of the shot areas on the substrate P can be subjected to the exposure by the liquid immersion method.

The controller CONT moves the measuring stage MST to the position opposite to or facing the optical element 2 of the projection optical system PL, for example, during the exchange of the substrate P, and forms the liquid immersion area AR2 on the measuring stage MST. In this case, by moving the substrate stage PST and the measuring stage MST in a state that the substrate stage PST and the measuring stage MST are allowed to approach closely to each other, and by arranging one of the stages to be opposite to the optical element 2 when the one stage is being exchanged with the other of the stages, the liquid immersion area AR2 is moved between the substrate stage PST and the measuring stage MST. The controller CONT executes the measurement in relation to the exposure (for example, the baseline measurement) by using at least one of the measuring devices (measuring members) provided on the measuring stage MST in a state that the liquid immersion area AR2 is formed on the measuring stage MST. Details of the operation for moving the liquid immersion area AR2 between the substrate stage PST and the measuring stage MST and the measuring operation of the measuring stage MST during the exchange of the substrate P are disclosed, for example, in International Publication No. 2005/074014 (corresponding to European Patent Application Publication No. 1713113) and International Publication No. 2006/013806. The exposure apparatus, which is provided with the substrate stage and the measuring stage, is disclosed, for example, in Japanese Patent Application Laid-open No. 11-135400 (corresponding to International Publication No. 1999/23692) and Japanese Patent Application Laid-open No. 2000-164504 (corresponding to United States Patent No. 6,897,963). The contents of United States Patent No. 6,897,963 is incorporated herein by reference within a range of permission of the domestic laws and ordinance of the designated state and the selected state.

### Step of Judging Presence or Absence of Abnormality

When the substrate P shown in Fig. 1 comes into contact with the liquid 1 of the liquid immersion area AR2 in the exposure step as described above, a part of components of the substrate P is eluted into the liquid 1 in some cases. For example, when a chemical amplification type resist is used as the photosensitive material on the substrate P, the chemical amplification type resist includes a base resin, a photo acid generator (PAG) contained in the base resin, and an amine-based substance called "quencher". When the resist as described above comes into contact with the liquid 1, a part of components of the resist, specifically PAG, the amine-based compound, etc. are eluted into the liquid 1 in some cases. Even in a case that the base material of the substrate P itself (for example, the silicon substrate) comes into contact with the liquid 1, there is such a possibility that a part of component of the base material (silicon, etc.) might be eluted into the liquid 1 depending on the substances for constructing the base material.

As described above, there is such a possibility that the liquid 1, which comes into contact with the substrate P, might contain a minute foreign matter such as particles composed of the resist residue, the impurities generated from the substrate P, etc. There is also such a possibility that the liquid 1 might contain a minute foreign matter such as the impurities and dust in the atmospheric air. Therefore, there is such a possibility that the liquid 1 recovered by the liquid recovery mechanism 20 might contain the foreign matter including various impurities, etc. In view of the above, the liquid recovery section 21 discharges the recovered liquid 1 to the outside. At least a part of the recovered liquid 1 may be cleaned by an internal processing apparatus, and then the cleaned liquid 1 may be returned to the liquid supply mechanism 10 so that the cleaned liquid 1 is reused.

It is feared that the foreign matter such as the particles, etc., which has the size larger than the meshes of the mesh filter 25 provided on the recovery port 24 of the nozzle member 30 shown in Fig. 1 and which enters into and mixes with the liquid 1 of the liquid immersion area AR2, might adhere to and remain on the liquid contact portion including a surface (outer surface) of the mesh filter 25, etc. It is feared that the foreign matter, which remains as described above, might enter into and mix with the liquid 1 of the liquid immersion area AR2 again during the exposure of the substrate P. If the foreign matter, which entered into and mixed with the liquid 1, adheres onto the substrate P, it is feared that any deficiency including the shape defect, etc. might arise in the pattern to be formed on the substrate P.

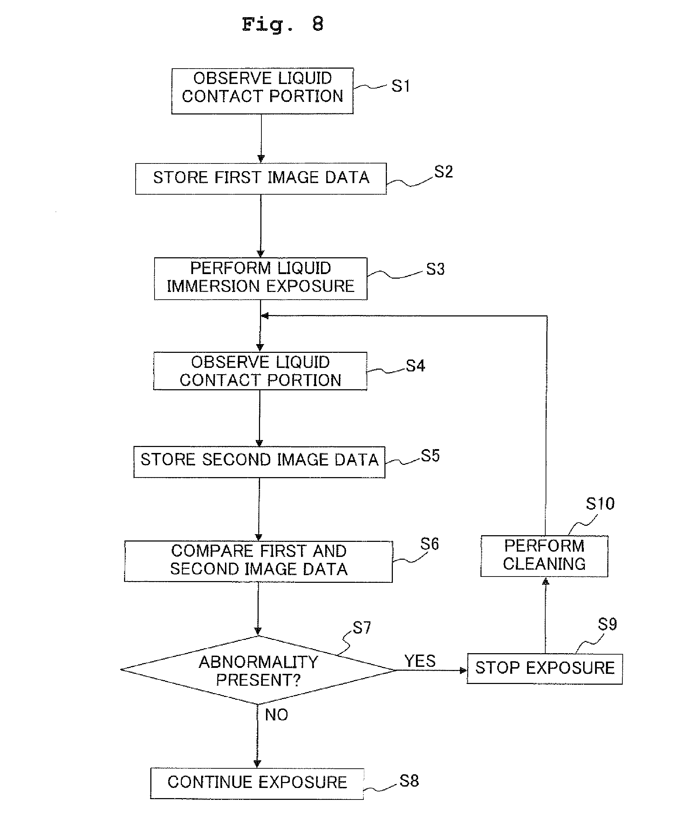

Accordingly, the exposure apparatus EX of this embodiment judges as follows whether the abnormality of the liquid contact portion is present or absent, i.e., whether or not the foreign matter, which has a size exceeding the allowable range, adheres to a plurality of predetermined observation objective portions (detection objective portions) included in the liquid contact portion in this embodiment. An explanation will be made below with reference to a flow chart shown in Fig. 8 about the exposure method according to this embodiment.

### First Step

At first, the portion, which is previously designated as the observation objective portion in the liquid contact portion of the exposure apparatus EX, is photographed (S1) by the alignment sensor ALG shown in Fig. 1 and/or the nozzle-observing device 65 shown in Fig. 6 before the start of the exposure step. The obtained first image data is stored as the reference observation information (reference information) in the image memory 58 (S2). In this procedure, for example, it is assumed that a wafer which is coated with the resist and which is the first wafer to be exposed among the wafers included in one lot as the exposure objective is loaded as the substrate P on the substrate holder PH.

Fig. 7 is a plan view illustrating the substrate stage PST shown in Fig. 1. With reference to Fig. 7, loci 60A, 60B, 60C represent the relative movement routes of the alignment sensor ALG relative to the substrate P and the substrate holder PH on the substrate stage PST. In reality, the alignment sensor ALG is allowed to stand still, and the substrate stage PST (as well as the measuring stage MST) is moved. However, Fig. 7 is depicted as if the alignment sensor ALG is relatively moved on the substrate stage PST for the convenience of the explanation.

In this procedure, in the case of this embodiment as described above, the four observation objective portions 68A to 68D are defined so that the areas disposed between the substrate P and the plate 97, to which the foreign matter easily adheres, are included. The shape of each of the observation objective portions 68A to 68D is actually same as the rectangular observation field brought about by the alignment sensor ALG, or the shape is such a shape that a plurality of the observation fields are connected in the X direction and the Y direction. When the baseline amount is measured, the alignment sensor ALG is moved along the locus 60C relative to the substrate holder PH as shown in Fig. 7 in a state that the substrate holder PH and the measuring table MTB shown in Fig. 5 are connected to each other, and the alignment sensor ALG is moved onto the reference mark area FM shown in Fig. 5. In this process, the liquid immersion area AR2 is formed between the projection optical system PL and the plate 97 or 101, and the movement is effected along the locus 60C at an extremely high velocity. Therefore, it is feared that the foreign matter might remain along the locus 60C. Accordingly, in this embodiment, a plurality of (two in this embodiment) observation objective portions 68E, 68F (having the same shape as that of the observation objective portion 68A) are also defined in an area on the plate 97 along the locus 60C. When the scanning exposure is performed for the shot area disposed in the vicinity of the edge of the substrate P, the liquid immersion area AR is moved while allowing a part thereof to protrude to the outside of the substrate P. Therefore, there is also such a possibility that the foreign matter might be deposited on the upper surface of the substrate stage PST (plate 97). Therefore, it is also allowable that at least one observation objective portion is defined in an area on the plate 97 on which the liquid immersion area AR is moved during the exposure.

As shown in Fig. 6, the area including the aperture pattern 62X on the measuring table MTB, from which the liquid-repellent coat 103 is removed, is also designated as the observation objective portion 68G to be observed by the alignment sensor ALG. The bottom surface of the mesh filter 25 of the nozzle member 30 is designated as the observation objective portion to be observed by the nozzle-observing device 65. Accordingly, at first, the observation objective portions 68A to 68F on the substrate holder PH shown in Fig. 7 and the observation objective portion 68G on the measuring table MTB shown in Fig. 6 are successively moved into the field of the alignment sensor ALG to photograph the images of the observation objective portions 68A to 68G. Pieces of the obtained first image data are each stored in the image memory 58. Subsequently, the measuring table MTB shown in Fig. 6 is driven in the X direction and the Y direction under or below the projection optical system PL, and the image of the substantially entire bottom surface of the mesh filter 25 of the nozzle member 30 is photographed by the nozzle-observing device 65. The obtained first image data (combination of a plurality of pieces of image data in this embodiment) is stored in the image memory 58.

In this procedure, the observation objective portion or portions may be further defined along with an area on the measuring table MTB shown in Fig. 5 as defined by extending the locus 60C. Other than the observation objective portions 68A to 68G described above, etc., any observation objective portion or portions of an arbitrary number having any arbitrary size may be also defined on the substrate holder PH (including the substrate P) and on the measuring table MTB. As for such observation objective portion or portions, pieces of the obtained first image data may be each also stored as the reference observation information in the image memory 58. As appreciated from Fig. 7, the locus 60A is substantially along the plurality of shot areas SH comparted on the substrate P, and resembles the movement route of the liquid immersion area AR2 during the exposure. However, the loci 60B, 60C are different from the movement route of the liquid immersion area AR2 during the exposure.

### Second Step

In this step, the pattern of the mask M is transferred onto the substrate P to perform the exposure (S3) by using the liquid immersion method and the alignment of the substrate P in the same manner as explained in the exposure step described above. In this procedure, the substrate P is moved relative to the projection area AR1 of the projection optical system PL shown in Fig. 1, for example, along the locus 60A shown in Fig. 7. In reality, the scanning direction of the mask M and the substrate P is inverted for each of the shot areas. Therefore, the locus 60A is the more complicated route. Further, the exposure is performed by using the alignment and the liquid immersion method for a predetermined number of substrates of the same lot. After the completion of the exposure of the predetermined number of substrates and before performing the exposure for the next substrate (also designated as the substrate P shown in Fig. 7), the image of the observation objective portion 68A described above, etc. is photographed (S4). The obtained second image data is stored as the detection objective observation information in the image memory 58 (S5).

In this procedure, it is assumed that the alignment of the substrate P shown in Fig. 7 is performed in accordance with the enhanced global alignment (EGA) system in which the alignment sensor ALG is used to detect the alignment marks disposed in the measuring areas 69A to 69H in a plurality of shot areas selected from the shot areas disposed on the substrate P, and the position information about each of the detected alignment marks is statistically processed to calculate the position information about each of the shot areas on the substrate P. The EGA system is disclosed, for example, in Japanese Patent Application Laid-open No. 61-44429 (corresponding to United States Patent No. 4,780,617). In this procedure, when the alignment sensor ALG is moved along the locus 60B relative to the substrate P to successively detect the alignment marks of the measuring areas 69A to 69H in order to perform the alignment for the substrate P, the images of one of the observation objective portions 68A to 68D disposed at the nearest position from the alignment sensor ALG is successively photographed by using the alignment sensor ALG. The obtained second image data are successively stored in the image memory 58 shown in Fig. 4. For example, when the alignment sensor ALG is relatively moved from the measuring area 69A to the measuring area 69B, the alignment sensor ALG is moved to the position over the observation objective portion 68A positioned at the position near thereto. Accordingly, the second image data of each of the observation objective portions 68A to 68D can be obtained without prolonging the alignment time. In this embodiment, the plurality of observation objective portions are respectively detected continuously to the detection of the alignment mark of the nearest detection objective among the detection objectives during the alignment operation, i.e., during the operation for detecting the alignment mark. However, there is no limitation to this. For example, it is also allowable to determine the detection sequence or order of the alignment marks and the detection objective portions in which the detection time is shortest, for example, in accordance with any genetic algorithm.

Upon measuring the baseline amount by relatively moving the alignment sensor ALG along the locus 60C before the exposure of the substrate P, the images of the observation objective portions 68E, 68F disposed at the intermediate positions of the locus 60C are photographed by using the alignment sensor ALG. Further, for example, upon measuring the image formation characteristic of the projection optical system PL by using the spatial image-measuring device 61 shown in Fig. 6, the observation objective portion 68G disposed over the spatial image-measuring device 61 is moved therebefore to the position under or below the alignment sensor ALG, and the image of the observation objective portion 68G is photographed via the alignment sensor ALG. Pieces of the second image data of the observation objective portions 68E to 68G obtained as described above are successively stored in the image memory 58.

For example, when the measuring table MTB is moved to the position under or below the projection optical system PL in order that the baseline amount is measured or the liquid immersion area AR2 is moved from the substrate stage PST to the measuring stage MST, then the measuring table MTB is driven as shown in Fig. 6, and the nozzle-observing device 65 is moved with respect to the substantially entire bottom surface of the mesh filter 25 of the nozzle member 30 to photograph the images of the mesh filter 25. Pieces of the obtained second image data are successively stored in the image memory 58. In this way, when the baseline amount is measured or when the image formation characteristic of the projection optical system PL is measured, for example, pieces of the second image data are obtained for the observation objective portion 68G on the measuring table MTB and the mesh filter 25 of the nozzle member 30 in combination, thereby making it possible to maintain the high throughput of the exposure step.

### Third Step

Subsequently, after the completion of the second step described above, the data processing device 57 shown in Fig. 4 (or Fig. 6) reads the first image data obtained in the first step and the second image data obtained in the second step respectively from the image memory 58 and compares the first image data and the second image data in relation to each of the observation objective portions under the control of the controller CONT shown in Fig. 1, to thereby identify a different portion of the two pieces of image data (S6). In this case, the different portion can be identified or specified at an extremely high speed, for example, by subtracting the second image data from the first image data for each data of each of the pixels. The specified or identified different portion can be regarded as the foreign matter adhered due to that the observation objective portion, corresponding to the identified different portion, is brought into contact with the liquid 1 during the exposure based on the liquid immersion method.

Accordingly, in a case that the identified different portion has a size of not less than a predetermined size (for example, 100 µm square) or in a case that the luminance (absolute value) of the image after the differential or subtracting process is not less than a predetermined value for each of the observation objective portions, then the data processing device 57 recognizes that the abnormality arises in the observation objection portion; and the data processing device 57 feeds, to the controller CONT shown in Fig. 1, the information (abnormality contents-information) including, for example, an abnormality occurrence position (position of the observation objective portion at which the abnormality arises) as well as the number of the different portion or portions, the size thereof, and the difference in the luminance (S7).
On the other hand, if the different portion is within an allowable range for every observation objective portion in the third step, the data processing device 57 judges that the abnormality is absent, and feeds the judgment result to the controller CONT. In this case, the exposure is performed for the substrate P as it is (S8). The second step and the third step described above are executed again.

### Fourth Step

Subsequently, if the judgment result of the presence of the abnormality and the abnormality contents-information are fed from the data processing device 57 to the controller CONT in the third step described above, as an example, the controller CONT stops the exposure for the substrate P (S9). A dummy substrate (cover member), which is constructed of, for example, a silicon substrate, is loaded on the substrate holder PH shown in Fig. 7 instead of the substrate P, and then the liquid contact portion is cleaned (S10). Specifically, the valve 23 shown in Fig. 1 is closed, and the valve 28 shown in Fig. 1 is opened to supply the cleaning liquid to the recovery port 24 of the nozzle member 30 from the cleaning liquid supply section 26 via the supply tube 27, the recovery tube 22, and the recovery flow passage 84. The cleaning liquid is supplied onto the substrate holder PH (plate 97) and onto the measuring table MTB, and then the supplied cleaning liquid is recovered by the liquid recovery section 21. By doing so, the liquid contact portion is cleaned. In this procedure, for example, a liquid sucking device may be previously provided in each of the substrate holder PH and the measuring table MTB to recover the cleaning liquid via the sucking device. For example, the cleaning liquid may be vibrated, for example, by an ultrasonic vibrator to supply the cleaning liquid onto the plate 97 or the measuring table MTB. The supply and the recovery of the cleaning liquid may be concurrently performed to form the liquid immersion area of the cleaning liquid, while the substrate stage PST or the measuring stage MST may be moved relative to the liquid immersion area. In the case of the latter, the number of particles in or contained in the cleaning liquid recovered from the liquid immersion area may be counted, for example, by a particle counter which will be described later on; and the cleaning operation may be controlled depending on the counted value. Further, the liquid contact portion may be cleaned by using the cleaning device for the measuring stage MST described above. In a case that the dummy substrate is liquid-attractive like the silicon substrate, the upper surface (surface) of the dummy substrate is subjected to the liquid-repelling process.
The liquid-repelling process includes, for example, the coating process in which a liquid-repellent coat is formed by coating a liquid-repellent material. The liquid-repellent material includes, for example, fluorine-based compounds, silicon compounds, and synthetic resins such as polyethylene. The liquid-repellent coat may be a single layer film or a film constructed of a plurality of layers.

After that, the second image data is obtained again regarding each of the observation objective portions 68A to 68G, etc. by using the alignment sensor ALG and the nozzle-observing device 65 (S4 and S5); and the second image data is compared with the first image data (S6), to thereby judge the presence or absence of the abnormality (S7). The exposure is performed for the substrate P (S8) at the point of time at which the abnormality disappears. After that, the operation is returned to the second step. The frequencies, at which the second image data is obtained for each of the observation objective portions in the second step and the image data comparison is performed in the third step, are arbitrary. The operation may be performed, for example, every time when the exposure is completed for substrates of several lots to several tens lots. The second and third steps may be executed every time when the exposure is completed for substrates of 1 lot or every time when the exposure is completed for a plurality of substrates included in a same lot, depending on the type of the film of the substrate (for example, the resist film and/or the top coat film), etc. The interval of the execution of the second and third steps described above may be gradually shortened, as the number of substrates to be subjected to the exposure process is increased. The first image data of each of the observation objective portions obtained in the first step may be periodically updated. In this case, the first step described above may be periodically executed. For example, the second image data (detected information), which is obtained after the cleaning operation for the liquid contact portion as described above, may be stored as the first image data (reference information).

By providing the step of judging the presence or absence of the abnormality as described above, the probability of execution of the exposure in the state that the foreign matter adheres to the substrate P is lowered, and the defect such as the shape deficiency of the transferred pattern is decreased. Therefore, it is possible to increase the yield of the device as the final product. The operation and the advantage, etc. of the exposure apparatus and the exposure method of this embodiment are summarized as follows. A1: In this embodiment, the first image data and the second image data are compared with each other for every observation objective portion. Therefore, it is possible to efficiently judge the presence or absence of the abnormality. That is, it is possible to efficiently judge whether or not any foreign matter, which has a fear of becoming the factor of an error of the pattern to be transferred, is adhered.

A2: If the abnormality arises in the third step of this embodiment, then the exposure is stopped in the fourth step, and the liquid contact portion is cleaned. Accordingly, in a case that the exposure is performed next time in accordance with the liquid immersion method, it is possible to reduce the probability that the foreign matter enters into and mixes with the liquid. In a case that the observation objective portion, in which the abnormality is found in the third step, is, for example, the observation objective portion 68G on the spatial image-measuring device 61 of the measuring table MTB shown in Fig. 6, or in a case that the size of the detected foreign matter is small and the number of the detected foreign matter or foreign matters is small, i.e., in a case that it is postulated that the foreign matter has a small possibility of adhesion via the liquid onto the substrate P even when the exposure is performed as it is, then the exposure may be performed for the substrate P as it is.

A3: The presence or absence of the abnormality, which is judged in the third step of this embodiment, is the presence or absence of the abnormality in relation to the observation objective portion. However, other than the above, for example, it is also appropriate to judge that the abnormality is present in a case that the amount of change of the reflectance distribution of the observation objective portion, which is measured by the spectrometer, is large.
A4: In this embodiment, in order to optically observe the state of the observation objective portions 68A to 68G, the alignment sensor ALG, which is of the image processing system for detecting the position of the alignment mark on the substrate P, is used. Therefore, it is possible to effectively utilize the alignment sensor ALG.

A5: In the second step described above, the process, in which the second image data is obtained regarding each of the observation objective portions 68A to 68D between the substrate P and the plate 97 shown in Fig. 7, is executed in combination when the positions of a plurality of the predetermined alignment marks on the substrate P are detected by using the alignment sensor ALG. Further, the process, in which the second image data is obtained regarding each of the two observation objective portions 68E, 68F on the plate 97, is executed when the baseline amount is measured by using the alignment sensor ALG. Therefore, the throughput of the exposure step is hardly lowered.

The process, in which the second image data of each of the observation objective portions 68A to 68D is obtained, may be executed distinctly from the alignment operation using the alignment sensor ALG. Also in this case, when the interval, at which the abnormality judgment is performed for the liquid contact portion, is long, the throughput of the exposure step is not lowered so much. A6: Further, in this embodiment, in order that the mesh filter 25, which is arranged on the liquid recovery port 24 of the nozzle member 30, is designated as the observation objective portion (part of the liquid contact portion), the nozzle-observing device 65 is arranged on the measuring table MTB shown in Fig. 6 on the measuring stage MST. Therefore, the state of a liquid contact portion, which cannot be observed by the alignment sensor ALG, can be optically observed. It is also possible to provide the nozzle-observing device 65 on the substrate stage PST (substrate holder PH).

A7: In this embodiment, the circular area 103a, on the measuring table MTB shown in Fig. 6, including the aperture pattern 62X in which the liquid-repellent coat 103 is removed or absent, is also designated as the observation objective portion 68G to be observed by the alignment sensor ALG. When the liquid is supplied, the foreign matter easily adheres to the circular area 103a. Therefore, the circular area 103a is appropriate as the observation objective portion. When the observation objective portion 68G and the observation objective portions 68E, 68F on the substrate holder PH shown in Fig. 7 are observed, each of the observation objective portions may be moved to the projection area of the projection optical system PL, the exposure light EL may be previously radiated, and the alignment sensor ALG may be used as the fluorescence microscope described above. In this case, when any foreign matter in the observation objective portions 68E to 68G has a property to emit the fluorescence, the foreign matter can be easily detected by detecting the fluorescence by the alignment sensor ALG in some cases.

When the fluorescence is detected as described above, then also upon obtaining the first image data of each of the observation objective portions 68E to 68G in the first step described above, the exposure light EL may be radiated, and the alignment sensor ALG may be used as the fluorescence microscope. A8: In this embodiment, the alignment sensor ALG and the nozzle-observing device 65 are used as the devices to optically observe the liquid contact portion. However, other than the above, it is also possible to use the spectrometer described above. Further, it is also possible to use the spectrometer and the image pickup device in combination. It is also allowable to optically detect (observe) the liquid contact portion by using an optical sensor of a system other than the image pickup (image processing) system.

In the embodiment described above, the process for obtaining the second image data of the observation objective portions 68A to 68D is performed after the exposure operation for exposing the substrate P. However, the process for obtaining the second image data may be executed after any operation other than the exposure operation. In the embodiment described above, the presence or absence of the abnormality is judged taking notice of the size and/or the luminance (difference) of the identified different portion of the observation objective portion. However, it is also allowable that the presence or absence of the abnormality is judged by using any other characteristic (for example, the density of the different portion) instead of the absence/presence or in combination with the absence/presence.

In the embodiment described above, the first image data of the observation objective portion is obtained in such a state that the substrate P is held by the substrate holder PH in the first step. However, there is no limitation to this. For example, the first image data of the observation objective portion may be obtained in such a state that the dummy substrate described above is held by the substrate holder PH. In this case, the position and/or the size of the observation objective portion, etc. may be defined so that the dummy substrate and the substrate P are not included in the observation objective portion on the substrate holder PH in the first step and the second step. In the embodiment described above, the first step, in which the first image data of the observation objective portion is obtained, is executed immediately before the exposure operation. However, there is no limitation to this. The first image data may be obtained irrelevant to the exposure operation. For example, the first image data may be obtained during the adjustment, the maintenance for the exposure apparatus, etc. Further, in the embodiment described above, the first image data of the observation objective portion is stored as the reference information. However, for example, when the observation objective portion is detected by using the fluorescence microscope as described above, the fluorescence (or the phosphorescence), which is emitted from the foreign matter such as any organic matter, is received. Therefore, the foreign matter of the observation objective portion can be detected without using the reference information. Therefore, it is also allowable that the reference information (first image data) is not obtained.

In the embodiment described above, the abnormality judgment (as well as the cleaning of the liquid contact portion) is performed as a part of the exposure operation. However, the abnormality judgment described above, etc. may be performed, for example, during the maintenance independently from the exposure operation. In the embodiment described above, the second and third steps are simultaneously executed in relation to the plurality of observation objective portions. However, for example, the second and third steps may be executed in relation to a part or parts of the plurality of observation objective portions at any timing and/or an interval different from those of the other observation objective portions. Further, in the embodiment described above, the plurality of observation objective portions are defined on the substrate holder PH (plate 97), the nozzle member 30, the measuring table MTB, etc. However, for example, the position or positions and/or the number of the observation objective portion or portions is/are not limited to this, and may be arbitrary. In the embodiment described above, the plurality of specified or identified observation objective portions are observed. However, any observation objective portion or portions different from the identified observation objective portions may be observed in place thereof or in combination therewith. Only a part or parts of the plurality of identified observation objective portions may be observed.

### Second Embodiment

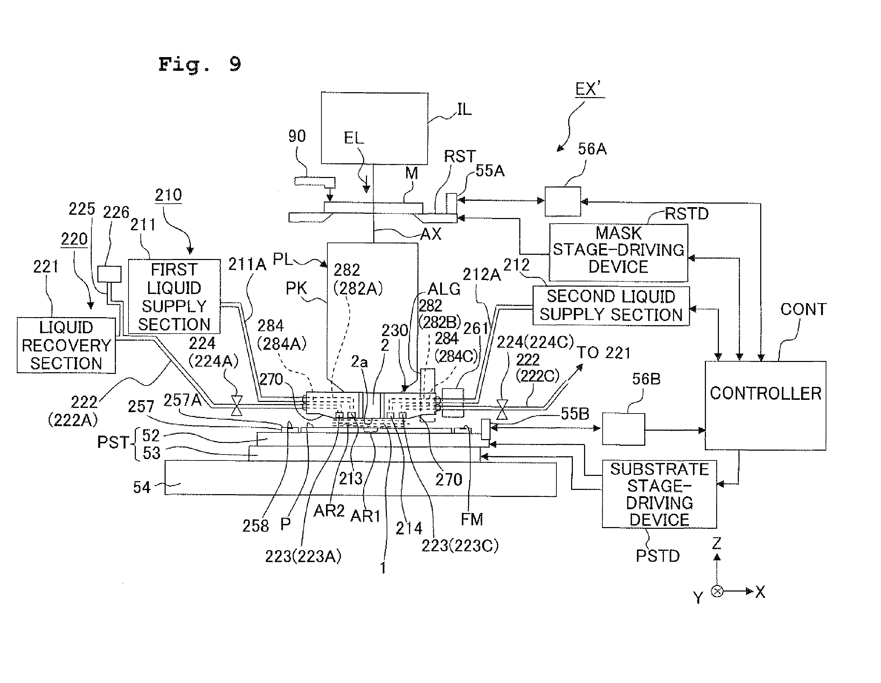

An exposure apparatus EX' and an exposure method according to the second embodiment of the present invention will be explained with reference to Figs. 9 to 15. In the following description, the constitutive parts or components, which are same as or equivalent to those of the first embodiment, are designated by the same reference numerals, any explanation of which will be simplified or omitted.

Fig. 9 is a schematic construction view of the scanning type exposure apparatus EX' of this embodiment. With reference to Fig. 9, the exposure apparatus EX' includes a mask stage RST which supports a mask M; a substrate stage PST which supports a substrate P; an illumination optical system IL which illuminates, with an exposure light EL, the mask M supported by the mask stage RST; a projection optical system PL which projects an image of a pattern (pattern image) of the mask M illuminated with the exposure light EL onto the substrate P supported by the substrate stage PST; a controller CONT which integrally controls the operation of the entire exposure apparatus EX'; a liquid immersion system (liquid immersion mechanism) which is provided for the application of the liquid immersion method; and an alignment sensor ALG of, for example, the image processing system and provided to perform the alignment for the substrate P by detecting an alignment mark on the substrate P. The liquid immersion system of this embodiment includes a liquid supply mechanism 210 which supplies the liquid 1 onto the substrate P, and a liquid recovery mechanism 220 which recovers the liquid 1 supplied onto the substrate P. The exposure apparatus EX' adopts the local liquid immersion system in the same manner as in the first embodiments; and irradiates the exposure light EL passing through the mask M onto the substrate P via the projection optical system PL and the liquid 1 between the projection optical system PL and the substrate P, thereby transferring the pattern of the mask M onto the substrate P to perform the exposure.

The structures of the illumination optical system IL, the mask stage RST, and the projection optical system PL provided for the exposure apparatus EX' are same as or equivalent to those of the first embodiment. Therefore, any explanation thereof will be omitted. Pure or purified water is used as the liquid 1 in the exposure apparatus EX' of this embodiment as well. However, unlike the first embodiment, the measuring stage is not provided. Various measuring functions are provided on the substrate stage as described later on.

The substrate stage PST is provided with a Z stage 52 which holds the substrate P via a substrate holder (not shown), and an XY stage 53 which supports the Z stage 52. The substrate stage PST is placed on a base 54, for example, with a gas bearing intervening therebetween so that the substrate stage PST is movable two-dimensionally. A reflecting mirror 55B is provided on the Z stage 52. A laser interferometer 56B is provided at a position opposite to or facing the reflecting mirror 55B. The position in the two-dimensional direction and the angle of rotation of the Z stage 52 (substrate P) are measured in real-time by the laser interferometer 56B. An obtained result of the measurement is outputted to the controller CONT. The substrate stage PST is driven by a substrate stage-driving device PSTD including, for example, a linear motor. The substrate stage-driving device PSTD is controlled by the controller CONT to move or position the substrate stage PST (substrate P) in the same manner as in the first embodiment.

An annular plate 257 is provided on the substrate stage PST (Z stage 52) to surround the substrate P. The plate 257 has a flat surface 257A which a height approximately same as that of the surface of the substrate P held by the substrate holder. In this case, for example, a gap of about 0.1 to 1 mm is provided between the plate 257 and the edge of the substrate P. However, in this embodiment, the resist of the substrate P is liquid-repellent (to have a property to repel the liquid 1), and the liquid 1 has the surface tension. Therefore, the liquid 1 is scarcely allowed to inflow into the gap. Even when a portion, of the substrate P, located in the vicinity of the circumferential edge is subjected to the exposure, it is possible to retain the liquid 1 between the plate 257 and the projection optical system PL. For example, when the substrate holder is provided with a sucking mechanism for discharging the liquid allowed to inflow into the gap, it is not necessarily indispensable that the resist (or the top coat) of the substrate P is liquid-repellent.

The liquid supply mechanism 210 is provided to supply the certain or predetermined liquid 1 onto the substrate P. The liquid supply mechanism 210 includes a first liquid supply section 211 and a second liquid supply section 212 which are capable of feeding the liquid 1, and first and second supply tubes 211A, 212A each of which has one end connected to one of the first and second liquid supply sections 211, 212. Each of the first and second liquid supply sections 211, 212 is provided with a tank for accommodating the liquid 1, a pressurizing pump, etc. It is not necessarily indispensable that the liquid supply mechanism 210 is provided with all of the tank, the filter section, the pressurizing pump, etc. At least a part or parts thereof may be substituted, for example, with any equipment of the factory or the like in which the exposure apparatus EX' is installed.

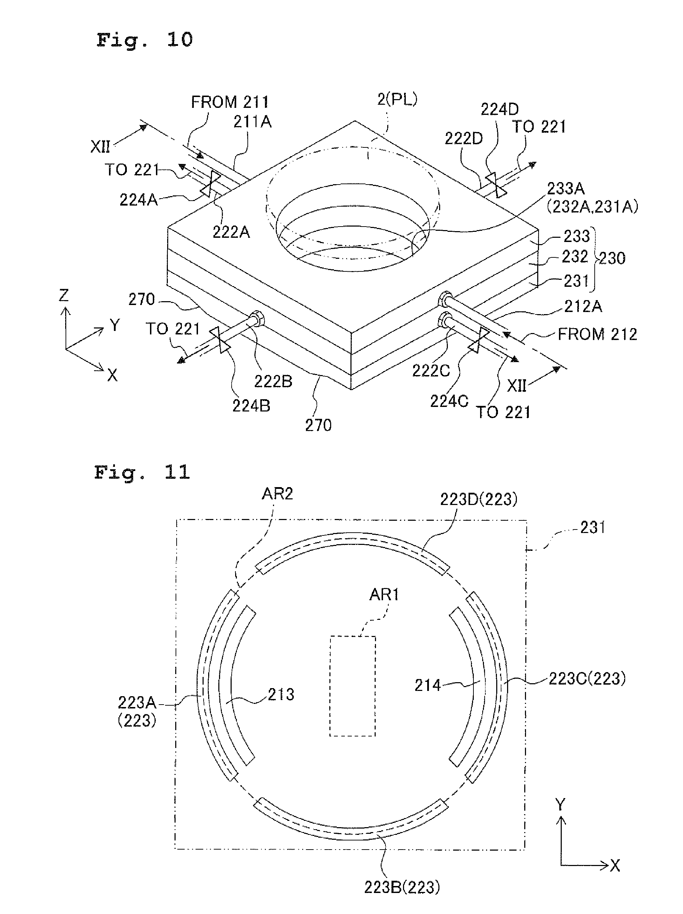

The liquid recovery mechanism 220 is provided to recover the liquid 1 supplied onto the substrate P. The liquid recovery mechanism 220 includes a liquid recovery section 221 which is capable of recovering the liquid 1, and a recovery tube 222 (constructed of first to fourth recovery tubes 222A, 222B, 222C, 222D, see Fig. 10) which has one end connected to the liquid recovery section 221. A valve 224 (constructed of first to fourth valves 224A, 224B, 224C, 224D, see Fig. 10) is provided at an intermediate position of the recovery tube 222 (222A to 222D). The liquid recovery section 221 is provided with, for example, a vacuum system (sucking device) such as a vacuum pump, and a tank for accommodating the recovered liquid 1. It is not necessarily indispensable that the liquid recovery mechanism 220 is provided with all of the vacuum system, the tank, etc. At least a part or parts thereof may be substituted, for example, with any equipment of the factory or the like in which the exposure apparatus EX' is installed.

A particle counter 226, which measures the number of minute particles as the foreign matter, is connected to an intermediate portion of the recovery tube 222 via a branch tube 225. As an example, the particle counter 226 is operated as follows. That is, a predetermined volume of the liquid is extracted at a predetermined sampling rate from the liquid flowing through the recovery tube 222; a laser beam is radiated onto the extracted liquid; and an image of scattered light is subjected to the image processing. With this, the number of particles in the liquid is measured. The measured number of particles is supplied to the controller CONT. The particle counter 226 may be provided independently for each of the four recovery tubes 222A to 222D. However, the particle counter 226 may be representatively provided for only one recovery tube (for example, the recovery tube 222A). In a case that four pieces of the particle counter 226 are provided for the four recovery tubes 222A to 222D respectively, for example, the average value of the numbers of particles measured by the four particle counters 226 may be used as the measured value of the number of particles.

A nozzle member 230 is arranged as the flow passage-forming member in the vicinity of the optical element 2 at the terminal end of the projection optical system PL. The nozzle member 230 is an annular member which is provided to surround the circumference of the optical element 2, at a position over or above the substrate P (substrate stage PST). The nozzle member 230 is provided with a first supply port 213 and a second supply port 214 (see Fig. 11) which are arranged opposite to or facing the surface of the substrate P. The nozzle member 230 has a supply flow passage 282 (282A, 282B) at the inside thereof. One end of the supply flow passage 282A is connected to the first supply port 213, and the other end is connected to the first liquid supply section 211 via the first supply tube 211A. One end of the supply flow passage 282B is connected to the second supply port 214, and the other end is connected to the second liquid supply section 212 via the second supply tube 212A. Further, the nozzle member 230 is provided with four recovery ports 223 (see Fig. 11) which are provided over or above the substrate P (substrate stage PST) and which are arranged opposite to or facing the surface of the substrate P.

Fig. 10 is a perspective view schematically illustrating the nozzle member 230. As shown in Fig. 10, the nozzle member 230 is the annular member which is provided to surround the circumference of the optical element 2 at the terminal end of the projection optical system PL. The nozzle member 230 is provided with a first member 231, a second member 232 which is arranged on the upper portion of the first member 231, and a third member 233 which is arranged on the upper portion of the second member 232. The first to third members 231 to 233 are plate-shaped members respectively, and have holes 231A to 233A each of which is located at the central portion thereof and in which the projection optical system PL (optical element 2) can be arranged.

Fig. 11 shows the first member 231 which is included in the first to third members 231 to 233 shown in Fig. 10 and which is arranged at the lowermost section thereof. With reference to Fig. 11, the first member 231 is provided with the first supply port 213 which is formed on a side in the -X direction of the projection optical system PL and which supplies the liquid 1 onto the substrate P, and the second supply port 214 which is formed on a side in the +X direction of the projection optical system PL and which supplies the liquid 1 onto the substrate P. Each of the first supply port 213 and the second supply port 214 is a through-hole which penetrates through the first member 231 and which is formed to have a substantially circular arc-shaped form as seen in a plan view. Further, the first member 231 is provided with the first recovery port 223A, the second recovery port 223B, the third recovery port 223C, and the fourth recovery port 223D which are formed on the sides in the -X direction, the -Y direction, the +X direction, and the +Y direction respectively of the projection optical system PL and each of which recovers the liquid 1 on the substrate P. Each of the first to fourth recovery ports 223A to 223D is also a through-hole which penetrates through the first member 231 and which is formed to have a substantially circular arc-shaped form as seen in a plan view. The first to fourth recovery ports 223A to 223D are provided at substantially equal intervals along with the circumference of the projection optical system PL, and are disposed at the outside of the projection optical system PL with respect to the supply ports 213, 214. A spacing distance between the supply ports 213, 214 and the substrate P and a spacing distance between the recovery ports 223A to 223D and the substrate P are provided substantially identically. In other words, the height positions of the supply ports 213, 214 and the height positions of the recovery ports 223A to 223D are provided approximately identically.

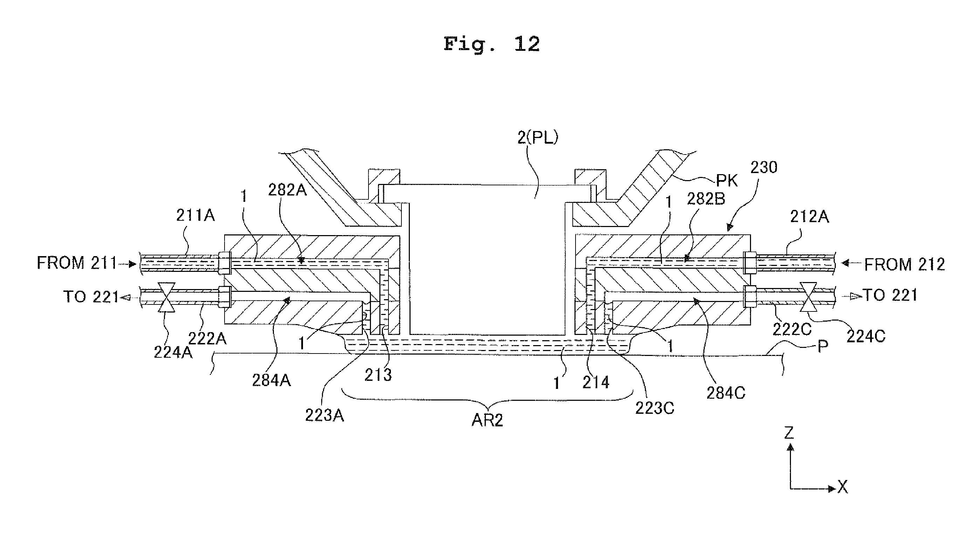

With reference to Fig. 9 again, the nozzle member 230 has recovery flow passages 284 (284A, 284B, 284C, 284D) formed therein and communicated with the recovery ports 223A to 223D (see Fig. 11). The recovery flow passages 284B, 284D (not shown) are flow passages to make communication between the recovery ports 223B, 223D disposed in the non-scanning direction as shown in Fig. 11 and the recovery tubes 222B, 222D shown in Fig. 12. The other ends of the recovery flow passages 284A to 284D are communicated with the liquid recovery section 221 via the recovery tubes 222A to 222D respectively shown in Fig. 10. In this embodiment, the nozzle member 230 forms a part of the liquid supply mechanism 210 and a part of the liquid recovery mechanism 220. That is, the nozzle member 230 is a part of the liquid immersion mechanism of this embodiment.

The first to fourth valves 224A to 224D, which are provided for the first to fourth recovery tubes 222A to 222D shown in Fig. 10, open/close the flow passages of the first to fourth recovery tubes 222A to 222D respectively, and the operations of the valves 224A to 224D are controlled by the controller CONT shown in Fig. 9. The liquid recovery mechanism 220 is capable of sucking and recovering the liquid 1 from the recovery ports 223 (223A to 223D) during a period in which the flow passages of the recovery tubes 222 (222A to 222D) are open. When the flow passages of the recovery tubes 222 (222A to 222D) are closed by the valves 224 (224A to 224D), the sucking and the recovery of the liquid 1 via the recovery ports 223 (223A to 223D) are stopped.

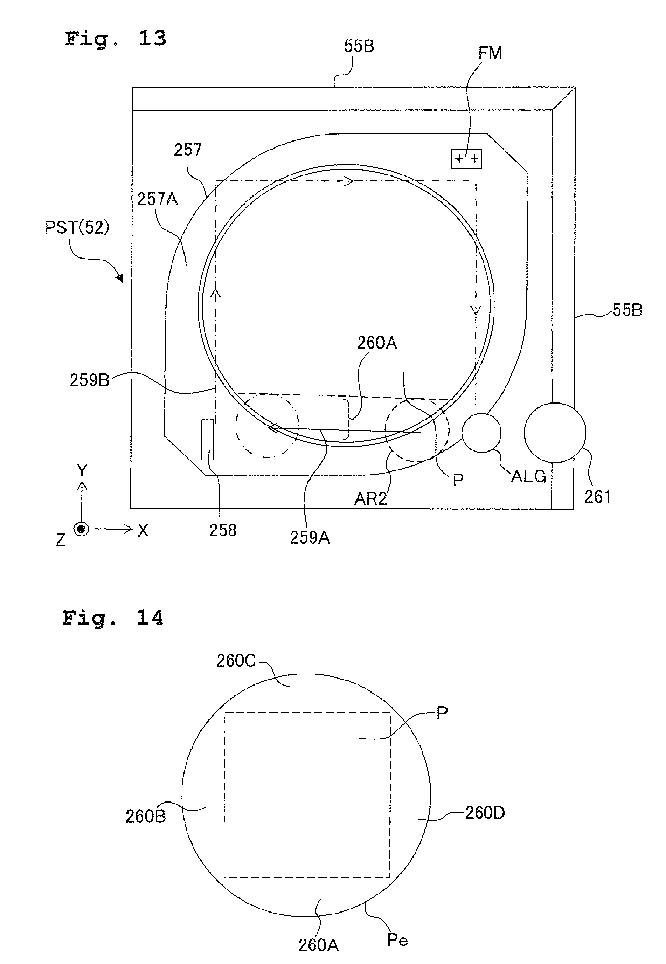

With reference to Fig. 9, the liquid supply operations of the first and second liquid supply sections 211, 212 are controlled by the controller CONT. The controller CONT is capable of independently controlling the liquid supply amounts per unit time to be supplied onto the substrate P by the first and second liquid supply sections 211, 212 respectively. The liquid 1, which is fed from the first and second liquid supply sections 211, 212, is supplied onto the substrate P from the supply ports 213, 214 (see Fig. 13) provided on the lower surface of the nozzle member 230 (first member 231) to be opposite to or face the substrate P, via the supply tubes 211A, 212A and the supply flow passages 282A, 282B of the nozzle member 230.

The liquid recovery operation of the liquid recovery section 221 is controlled by the controller CONT. The controller CONT is capable of controlling the liquid recovery amount per unit time to be recovered by the liquid recovery section 221. The liquid 1 on the substrate P, recovered from the recovery ports 223 provided on the lower surface of the nozzle member 230 (first member 231) to be opposite to the substrate P, is recovered by the liquid recovery section 221 via the recovery tubes 222 and the recovery flow passages 284 of the nozzle member 230. A liquid trap surface (inclined surface) 270, which has a predetermined length to capture the liquid 1, is formed on the lower surface (surface directed toward the substrate P) of the nozzle member 230, the lower surface being located at the outside of the projection optical system PL with respect to the recovery ports 223. The trap surface 270 is subjected to the liquid-attracting process. The liquid 1, which outflows to the outside of the recovery ports 223, is captured by the trap surface 270.

Fig. 11 is also a plan view illustrating the positional relationship between the projection area AR1 of the projection optical system PL and the first and second supply ports 213, 214 and the first to fourth recovery ports 223A to 223D formed on the nozzle member 230 shown in Fig. 10. With reference to Fig. 11, the projection area AR1 of the projection optical system PL is defined to have a rectangular shape in which the Y direction (non-scanning direction) is the longitudinal direction. The liquid immersion area AR2, which is filled with the liquid 1, is formed inside a substantially circular area which is substantially surrounded by the four recovery ports 223A to 223D so that the projection area AR1 is included therein. Further, the liquid immersion area AR2 is locally formed on a part of the surface of the substrate P (or to include a part of the surface of the substrate P) during the scanning exposure.

The first and second supply ports 213, 214 are formed to have a substantially circular arc-and slit-shaped forms on the both side of the projection area AR1 to interpose the projection area AR1 between the first and second supply ports 213, 214 in relation to the scanning direction (X direction). The length of the supply port 213, 214 in the Y direction is longer than at least the length of the projection area AR1 in the Y direction. The liquid supply mechanism 210 is capable of supplying the liquid 1 simultaneously on the both sides of the projection area AR1 from the two supply ports 213, 214.

The first to fourth recovery ports 223A to 223D are formed to have a circular arc-and slit-shaped forms to surround the supply ports 213, 214 and the projection area AR1. The recovery ports 223A, 223C, which are included in the plurality of (four) recovery ports 223A to 223D, are arranged on the both sides of the projection area AR1 while interposing the projection area AR1 between the recovery ports 223A, 223C in relation to the X direction (scanning direction). The recovery ports 223B, 223D are arranged on the both sides of the projection area AR1 while interposing the projection area AR1 between the recovery ports 223B, 223D in relation to the Y direction (non-scanning direction). The lengths of the recovery ports 223A, 223C in the Y direction are longer than the lengths of the supply ports 213, 214 in the Y direction. The recovery ports 223B, 223D are formed to have approximately the same lengths as those of the recovery ports 223A, 223C respectively as well. The recovery ports 223A to 223D are communicated with the liquid recovery section 221 shown in Fig. 9 via the recovery tubes 222A to 222D respectively shown in Fig. 10. In this embodiment, the number of the recovery ports 223 is not limited to four. Single or any arbitrary plural number of recovery port or ports 223 may be provided on condition that the recovery port or ports 223 is/are arranged to surround the projection area AR1 and the supply ports 213, 214.

The nozzle member 230 used in the embodiment described above is not limited to the structure described above. For example, it is also possible to use those described in European Patent Application Publication No. 1420298, International Publication Nos. 2004/055803, 2004/057589, and 2004/057590, and International Publication No. 2005/029559 (corresponding to United States Patent Application Publication No. 2006/0231206).

In this embodiment, the supply ports 213, 214 and the recovery ports 223A to 223D for the liquid are provided for the same nozzle member 230. However, the supply ports 213, 214 and the recovery ports 223A to 223D may be provided for distinct members. Further, for example, as disclosed in International Publication No. 2005/122218, a second recovery port (nozzle) for recovering the liquid may be provided outside the nozzle member 230. Further, it is also allowable that the supply ports 213, 214 are not arranged opposite to the substrate P. Further, the lower surface of the nozzle member 230 is defined to be at a height (Z position) approximately same as that of the lower end surface (light exit surface) of the projection optical system PL. However, for example, the lower surface of the nozzle member 230 may be defined at a position nearer to the image plane side (substrate side) as compared with the lower end surface of the projection optical system PL. In this case, a part (lower end portion) of the nozzle member 230 may be provided to extend crawlingly until arrival at a position under the projection optical system PL (optical element 2) so that the exposure light EL is not blocked.

Fig. 13 is a plan view illustrating the Z stage 52 of the substrate stage PST as seen from an upper position. With reference to Fig. 13, reflecting mirrors 55B are arranged at two mutually perpendicular edge portions of the Z stage 52 having a rectangular shape as seen in a plan view. The substrate P is held at an approximately central portion of the Z stage 52. An annular plate 257, which has a flat surface 257A having a height approximately same as that of the surface of the substrate P, is provided integrally with the Z stage 52 so that the circumference of the substrate P is surrounded by the plate 257.

Two corners of the flat surface 257A of the plate 257 have broad widths. Reference marks FM, which are used when the mask M and the substrate P are subjected to the alignment with respect to a predetermined position, are provided in one of the broad width portions. The reference mark FM is detected via the mask M and the projection optical system PL by a mask alignment system 90 (see Fig. 9) provided over or above the mask M. In other words, the mask alignment system 90 constitutes the alignment system of the so-called TTM (through the mask) system. The alignment sensor ALG of this embodiment is the FIA (Field Image Alignment) system, i.e., the alignment sensor of the off-axis system including an illumination system which illuminates an area in which a detection objective mark is formed, an imaging optical system which forms an image of the detection objective mark, and an image pickup device or element which photoelectrically converts the image, as disclosed, for example, in Japanese Patent Application Laid-open No. 7-183186 (corresponding to United States Patent No. 5,684,569). By processing the image pickup signal from the alignment sensor ALG with the image processing section included in the controller CONT shown in Fig. 9, it is possible to determine the positional deviation amount of the image of the detection objective mark with respect to the predetermined reference mark, as well as the X coordinate and the Y coordinate of the detection objective mark. It is possible to perform the alignment for the substrate P based on the coordinates.

The image processing section of this embodiment is also provided with a function to detect the presence or absence of the exfoliation of the film (the resist, etc.) of the surface of the substrate P (photographed area), based on the image pickup signal of the alignment sensor ALG. Further, a film thickness-measuring device 261, which measures the film thickness of the resist or the like coated on the substrate P, is provided in the vicinity of the alignment sensor ALG of the exposure apparatus EX' of this embodiment. A measurement result of this device is also supplied to the controller CONT. The film thickness-measuring device 261 measures the film thickness based on, as an example, the state of the interference fringes of the laser beam (the interference fringes of equal thickness, etc.). An ellipsometer, which detects the change of the polarization state of the reflected light beam (the elliptic polarization, etc.), can be also used as the film thickness-measuring device 261.

An optical sensor 258 is provided in the other broad width portion of the flat surface 257A of the plate 257. The optical sensor 258 detects the exposure light EL allowed to pass through the projection optical system PL. The optical sensor 258 is constructed of an illuminance sensor which detects the radiation amount (illuminance) of the exposure light EL on the image plane side of the projection optical system PL or an uneven illuminance sensor which detects the illuminance distribution (uneven illuminance) of the projection area AR1.

With reference to Fig. 9, a plurality of shot areas are defined on the substrate P. The controller CONT successively exposes the plurality of shot areas defined on the substrate P. In this embodiment, the controller CONT moves the substrate stage PST (XY stage 53) and successively exposes the plurality of shot areas, while monitoring the output of the laser interferometer 56B, so that the optical axis AX of the projection optical system PL (projection area AR1) is advanced along the predetermined locus relative to the substrate P. That is, a part of the pattern image (partial pattern image) of the mask M is projected onto the rectangular projection area AR1 just under or below the terminal end portion of the projection optical system PL during the scanning exposure for the substrate P. The mask M is moved at a velocity V in the X direction with respect to the projection optical system PL, in synchronization with which the substrate P is moved at a velocity β•V (β represents the projection magnification) in the X direction via the XY stage 53. After the completion of the exposure of one shot area on the substrate P, another shot area to be exposed next is moved to the scanning start position in accordance with the step-movement of the substrate P. The scanning exposure process is successively performed for the respective shot areas thereafter while moving the substrate P in the step-and-scan manner.

The controller CONT drives the liquid supply mechanism 210 during the exposure process for the substrate P to perform the liquid supply operation for supplying the liquid onto the substrate P. The liquid 1, which is fed from each of the first and second liquid supply sections 211, 212 of the liquid supply mechanism 210, flows through the supply tubes 211A, 212A, and then the liquid 1 is supplied onto the substrate P via the supply flow passages 282A, 282B formed in the nozzle member 230. The liquid 1 supplied onto the substrate P flows under or below the projection optical system PL in conformity with the movement of the substrate P. For example, when the substrate P is moved in the +X direction during the exposure of a certain shot area, the liquid 1 flows under or below the projection optical system PL at a velocity approximately same as that of the substrate P in the +X direction which is the same as the moving direction of the substrate P. In this state, the exposure light EL, radiated from the illumination optical system IL and passed through the mask M, is irradiated onto the image plane side of the projection optical system PL, thereby exposing the substrate P with the pattern of the mask M via the projection optical system PL and the liquid 1 of the liquid immersion area AR2.

The controller CONT performs the supply of the liquid 1 onto the substrate P by the liquid supply mechanism 210 at least when the exposure light EL is irradiated onto the image plane side of the projection optical system PL, i.e., during the exposure operation for the substrate P. The liquid immersion area AR2 is formed satisfactorily by continuing the supply of the liquid 1 by the liquid supply mechanism 210 during the exposure operation. On the other hand, the controller CONT performs the recovery of the liquid 1 on the substrate P by the liquid recovery mechanism 220 at least when the exposure light EL is irradiated onto the image plane side of the projection optical system PL, i.e., during the exposure operation for the substrate P. It is possible to suppress the expansion of the liquid immersion area AR2 by continuously executing the recovery of the liquid 1 by the liquid recovery mechanism 220 during the exposure operation (when the exposure light EL is irradiated onto the image plane side of the projection optical system PL).

In this embodiment, the liquid supply mechanism 210 supplies the liquid 1 onto the substrate P simultaneously from the both sides of the projection area AR1 through the supply ports 213, 214 during the exposure operation. Accordingly, the liquid 1, supplied from the supply ports 213, 214 onto the substrate P, is satisfactorily spread in the space between the substrate P and the lower end surface of the optical element 2 at the terminal end of the projection optical system PL and the space between the substrate P and the lower surface of the nozzle member 230 (first member 231). The liquid immersion area AR2 is formed in a range which is wider than at least the projection area AR1.

Upon supplying the liquid 1 onto the substrate P from the both sides in the scanning direction of the projection area AR1, the controller CONT may control the liquid supply operations of the first and second liquid supply sections 211, 212 of the liquid supply mechanism 210 so that the liquid supply amount per unit time, which is to be supplied from a position approaching the projection area AR1 in relation to the scanning direction, may be set to be greater than the liquid supply amount which is to be supplied from a position on a side opposite to the position approaching the liquid immersion area AR1. In this case, for example, there is such a possibility that when the substrate P is moved in the +X direction, the amount of the liquid to be moved toward the side in the +X direction with respect to the projection area AR1 might be increased, and a large amount of the liquid might outflow to the outside of the substrate P. However, the liquid 1, which is moved toward the side in the +X direction, is captured by the trap surface 270 provided on the lower surface on the +X side of the nozzle member 230. Therefore, it is possible to suppress the inconvenience or problem which would be otherwise caused such that the liquid causes the scattering and the outflow to the surroundings of the substrate P, etc.

It is also allowable that the recovery operation for recovering the liquid 1 by the liquid recovery mechanism 220 is not performed during the scanning exposure, and the flow passage of the recovery tube 222 is opened after the completion of the exposure to recover the liquid 1 on the substrate P. As an example, the liquid 1 on the substrate P may be recovered by the liquid recovery mechanism 220 only during a partial period (at least a part of the stepping period) after the completion of the exposure for a certain shot area on the substrate P and until the start of the exposure for a shot area to be exposed next to the certain shot area.

The controller CONT continues the supply of the liquid 1 by the liquid supply mechanism 210 during the exposure of the substrate P. By continuing the supply of the liquid 1 as described above, it is possible not only to fill the space between the projection optical system PL and the substrate P with the liquid 1 satisfactorily, but also to avoid the generation of the vibration of the liquid 1 (so-called the water hammer phenomenon). In this way, all of the shot areas on the substrate P can be subjected to the exposure by the liquid immersion method.

When the substrate P shown in Fig. 9 comes into contact with the liquid 1 of the liquid immersion area AR2 in the exposure step as described above, a part of the component or components of the base material (for example, the silicon substrate) of the substrate P and/or the material coated on the base material is eluted into the liquid 1 in some cases. For example, in a case that a chemical amplification type resist is used as the photosensitive material of the substrate P as described above, the chemical amplification type resist includes a base resin, a photo acid generator (PAG) contained in the base resin, and an amine-based substance called "quencher". In a case that the resist as described above comes into contact with the liquid 1, the part of the component(s) of the resist, specifically, for example, PAG and the amine-based compound are sometimes eluted into the liquid 1. Even in a case that the base material of the substrate P itself comes into contact with the liquid 1, there is such a possibility that a part of the component(s) of the base material (silicon, etc.) might be eluted into the liquid 1 depending on the substances constructing the base material.

As described above, there is such a possibility that the liquid 1, which comes into contact with the substrate P, might contain a minute foreign matter such as particles composed of the resist residue, the impurities generated from the substrate P, etc. There is also such a possibility that the liquid 1 might contain a minute foreign matter such as the impurities and the dust in the atmospheric air. Therefore, there is such a possibility that the liquid 1, which is recovered by the liquid recovery mechanism 220, might contain the foreign matter including various impurities, etc. In view of the above, the liquid recovery mechanism 220 discharges the recovered liquid 1 to the outside. At least a part of the recovered liquid 1 may be cleaned by an internal processing apparatus, and then the cleaned liquid 1 may be returned to the liquid supply mechanism 210.

It is feared that the minute foreign matter such as the particles, which enters into and mixes with the liquid 1 of the liquid immersion area AR2, might adhere to and remain on the upper surface of the substrate stage PST. It is feared that the foreign matter which remains as described above and the foreign matter which includes the particles or the like eluted into the liquid 1 might enter into and mix with the liquid 1 of the liquid immersion area AR2 again during the exposure of the substrate P. If the foreign matter, which enters into and mixes with the liquid 1, adheres onto the substrate P, it is feared that any deficiency including, for example, the shape defect, might arise in the pattern to be formed on the substrate P.

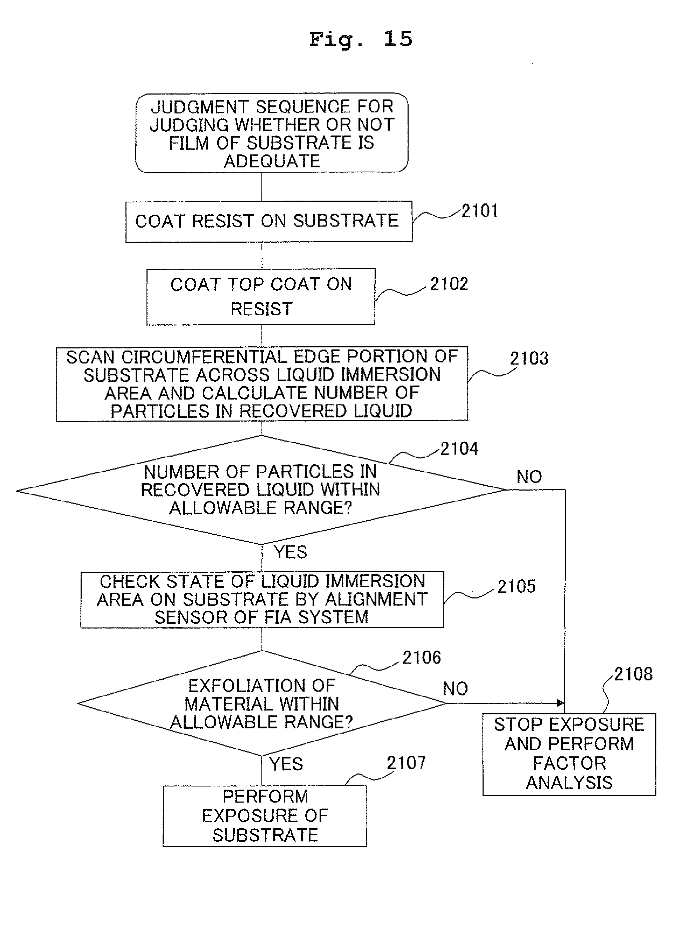

The amount of the foreign matter eluted from the substrate P into the liquid 1 as described above is changed depending on the type of the substrate P and the material disposed on the substrate P. Accordingly, in this embodiment, it is judged whether or not the film of the substrate P (resist film and/or top coat film) is adequate for the exposure based on the liquid immersion method in accordance with a judgment sequence shown in Fig. 15. At first, in Step 2101 shown in Fig. 15, the resist is coated on the base material of the substrate as the exposure objective by an unillustrated coater/developer. Subsequently, in Step 2102, the top coat is coated on the resist layer.

Subsequently, in Step 2103, the substrate P, which has the film of the resist and the film of the top coat, is loaded on the substrate stage PST of the exposure apparatus EX' shown in Fig. 9. After that, the liquid 1 is supplied from the liquid supply mechanism 210 to the space between the projection optical system PL and the circumferential edge portion of the substrate P as shown in Fig. 12 to form the liquid immersion area AR2 without radiating the exposure light EL, and the substrate P is moved in the X direction or the Y direction via the substrate stage PST with respect to the liquid immersion area AR2. That is, as shown in Fig. 13, for example, a circumferential edge portion 260A in the -Y direction, which includes the edge portion of the substrate P, is scanned along a locus 259A across relative to the liquid immersion area AR2. Subsequently, the substrate P is scanned across relative to the liquid immersion area AR2 along a locus 259B. By doing so, as shown in Fig. 14, circumferential edge portions 260B, 260C, 260D in the -X direction, the +Y direction, and the +X direction of the substrate P respectively are also scanned across the liquid immersion area AR2.

In this procedure, with reference to Fig. 9, the liquid 1 of the liquid immersion area AR2 is recovered by the liquid recovery section 221 of the liquid recovery mechanism 220 in the recovery amount per unit time which is approximately same as the supply amount per unit time of the liquid 1 supplied from the liquid supply mechanism 210 to the liquid immersion area AR2. Upon performing the recovery, the number of particles in the recovered liquid is counted at a predetermined sampling rate by the particle counter 226. A counted result is supplied to the controller CONT.

Subsequently, in Step 2104, the controller CONT judges whether or not the number of particles from the particle counter 226 is within a predetermined allowable range. If the number of particles is within the allowable range, then the operation proceeds to Step 2105, and the states of the circumferential edge portions 260A to 260D of the substrate P shown in Fig. 14 scanned across the liquid immersion area AR2 are photographed by the alignment sensor ALG not through the liquid 1. Subsequently, in Step 2106, the controller CONT judges whether or not the states of the resist film and the top coat film are normal in the areas of the circumferential edge portions 260A to 260D of the substrate P, especially at an edge portion Pe or in an area in the vicinity of the edge portion Pe, based on the images photographed by the alignment sensor ALG. More specifically, the controller CONT judges whether or not the exfoliation amounts of at least a part of the resist film and a part of the top coat film are within an allowable range. If the exfoliation amount of the film(s) is within the allowable range, the operation proceeds to Step 2107 to perform the exposure for the substrate P via the mask M by using the liquid immersion method.

On the other hand, if the number of particles of the recovered liquid exceeds the allowable range in Step 2104, and/or if the exfoliation amount of the material exceeds the allowable range in Step 2106, then the controller CONT judges that the resist film and/or the top coat film of the substrate P is/are not adequate for the exposure based on the liquid immersion method, and the operation proceeds to Step 2108 to stop the exposure for the substrate P. If necessary, the factor is analyzed about the fact that the resist film and/or the top coat film is/are not adequate for the exposure based on the liquid immersion method.

As described above, according to this embodiment, Steps 2101, 2103, 2105, and 2106 are executed. Therefore, it is possible to judge whether or not the film of the substrate P is adequate for the exposure based on the liquid immersion method, without actually performing the exposure for the substrate P. Therefore, the throughput of the device production is improved. Further, in this embodiment, the step (Step 2108) is provided to stop the exposure for the substrate P when the abnormality of the film (fact that the exfoliation amount of the film exceeds the allowable range in this case) is present or observed in Step 2106. Therefore, the exposure step to be performed thereafter does not turn out to be useless.

In this embodiment, the step (Step 2102) is provided to coat the resist surface of the substrate P with the top coat film. Therefore, it is also possible to judge whether or not the top coat is adequate for the exposure based on the liquid immersion method. In a case that the top coat film is not required on the resist film, it is also allowable to omit Step 2102. A top coat for the antireflection may be also coated in combination with the top coat for the resist protection or in place thereof in Step 2102.

The area on the substrate P, which is scanned across the liquid immersion area AR2 in Step 2103, includes at least a part of the edge portion of the substrate P. The exfoliation of the film of the resist or the like especially tends to occur at the edge portion. Therefore, it is possible to reliably judge whether or not the film material such as the resist is exfoliated by the exposure based on the liquid immersion method. In this embodiment, Steps 2101, 2103, and 2104 are executed to count the number of particles in the recovered liquid. Therefore, it is possible to judge whether or not the film material such as the resist of the substrate P is adequate for the exposure based on the liquid immersion method, i.e., whether or not the elution amount of the film material such as the resist into the liquid is within the allowable range, without actually performing the exposure for the substrate P.

In this embodiment, the number of particles contained in the liquid 1 is measured in order to detect the abnormality of the liquid 1 recovered from the recovery port 223 of the liquid recovery mechanism 220. However, in place of this or in combination with this, it is also allowable to measure, for example, the specific resistance of the recovered liquid 1, the metal ion, the total organic carbon (TOC), the number of bubbles, the viable cell count, the dissolved oxygen (DO) concentration, or the dissolved nitrogen (DN) concentration.

The following procedure is also available instead of the inspection of the state of the film of the substrate P by the alignment sensor ALG in Step 2105 in the judgment sequence shown in Fig. 15. That is, the substrate P is loaded on the substrate stage PST shown in Fig. 9, and then the substrate P is moved in the X direction and the Y direction under or below the film thickness-measuring device 261 shown in Fig. 13 to thereby measure the thickness distribution (dispersion or fluctuation of the film thickness) of the film disposed at the uppermost layer of the substrate P in the dry state that the liquid is not supplied. It is also allowable to judge whether or not the film thickness distribution is within an allowable range, i.e., whether or not the uneven coating of the film is within an allowable range. Accordingly, it is possible to easily judge whether or not the state of the film (uniformity of the thickness in this case) is adequate for the exposure based on the liquid immersion method, without actually performing the exposure.

As a result of the judgment, if it is considered that the fluctuation of the film thickness exceeds the allowable range and that the exfoliation easily arises or the bubble easily adheres (remains) when the exposure is performed in the liquid immersion method, then the exposure of the substrate P is stopped. In this case, the film may be exfoliated or removed, and the resist or the like may be coated again on the base material by the coater/developer. By performing the exposure after the fluctuation of the film thickness of the resist or the like is within the allowable range, it is possible to avoid the exposure step based on the liquid immersion method from being useless.

It is also allowable to perform both of the inspection of the film state of the substrate P by the alignment sensor ALG and the inspection of the film state by the film thickness-measuring device 261. The alignment sensor ALG for detecting the film state of the substrate P is not limited to the image processing system. When it is enough that the film state of the substrate P is inspected by only any one of the alignment sensor ALG and the film thickness-measuring device 261, then it is also allowable that any one of the alignment sensor ALG and the film thickness-measuring device 261, which is not used for the inspection, is not provided for the exposure apparatus EX'.

In this embodiment, it is judged whether or not the film of the substrate P (resist film and/or top coat film) is adequate for the liquid immersion exposure before exposing the substrate P. If it is judged that the film of the substrate P is adequate for the liquid immersion exposure (in the case of "Yes" in Step 2106), the liquid immersion exposure for the substrate P is executed. However, if it is enough to merely judge whether or not the state of the film of the substrate P or the material of the film is adequate for the liquid immersion exposure, it is also allowable that after Step 2106 in the sequence described above, the substrate P is recovered without performing the exposure for the substrate P. In a case that a plurality of types of materials are present as the materials for the film of the substrate P, Steps 2103 to 2106 described above are executed for each of the materials to execute the screening process in order to select the optimum material. In this embodiment, it is allowable that the dummy substrate explained in the first embodiment is arranged on the substrate stage PST instead of the substrate P; and that, for example, the number of particles in the liquid recovered from the liquid immersion area AR2 formed on the dummy substrate is measured by the particle counter to thereby obtain the information about the abnormality of the nozzle member 230 (the presence or absence of the foreign matter, etc.).

In the first and second embodiments, the interferometer system (51, 56, 56A to 56C) is used to measure the position information about each of the mask stage RST, the substrate stage PST, and the measuring stage MST. However, there is no limitation to this. For example, it is also allowable to use an encoder system for detecting a scale (diffraction grating) provided on each of the stages. In this case, it is preferable that a hybrid system including both of the interferometer system and the encoder system is provided, and the measurement result of the encoder system is calibrated (subjected to the calibration) by using the measurement result of the interferometer system. The position control of the stage may be performed by switchingly using the interferometer system and the encoder system or using both of the interferometer system and the encoder system.

In the first and second embodiments, the substrate holder PH and the substrate stage PST may be formed as an integrated body. Alternatively, the substrate holder PH and the substrate stage PST may be constructed separately, and the substrate holder PH may be fixed to the substrate stage PST, for example, by the vacuum attraction. The present invention according to the first embodiment is also applicable to an exposure apparatus in which various measuring devices (measuring members) are provided on the substrate stage PST (exposure apparatus not provided with the measuring stage MST). The present invention according to the second embodiment is also applicable to an exposure apparatus which is provided with the measuring stage provided with various measuring devices. Only a part or parts of various measuring devices may be provided on the measuring stage MST or the substrate stage PST, and the remaining part of the various measuring devices may be provided at the outside or on any distinct member. The particle counter 226 described in the second embodiment may be introduced into the exposure apparatus EX of the first embodiment to perform the process explained in the second embodiment.

In the first and second embodiments described above, water (pure or purified water) is used as the liquid 1 to be used for the liquid immersion method. However, it is also allowable to use any liquid other than water. For example, in a case that the light source of the exposure light EL is the F₂ laser (wavelength: 157 nm), the liquid 1 may be, for example, fluorine-based fluids such as fluorine-based oil or perfluoropolyether (PFPE). Alternatively, other than the above, it is also possible to use, as the liquid 1, those (for example, cedar oil) which have the transmittance with respect to the exposure light EL, which have the refractive index as high as possible, and which are stable against the resist coated on the surface of the substrate P and the projection optical system PL. Those having refractive indexes higher than those of silica glass and calcium fluoride (refractive index of about 1.6 to 1.8) may be used as the liquid 1. Further, the optical element 2 may be formed of a material having a refractive index (for example, not less than 1.6) higher than those of silica glass and calcium fluoride.

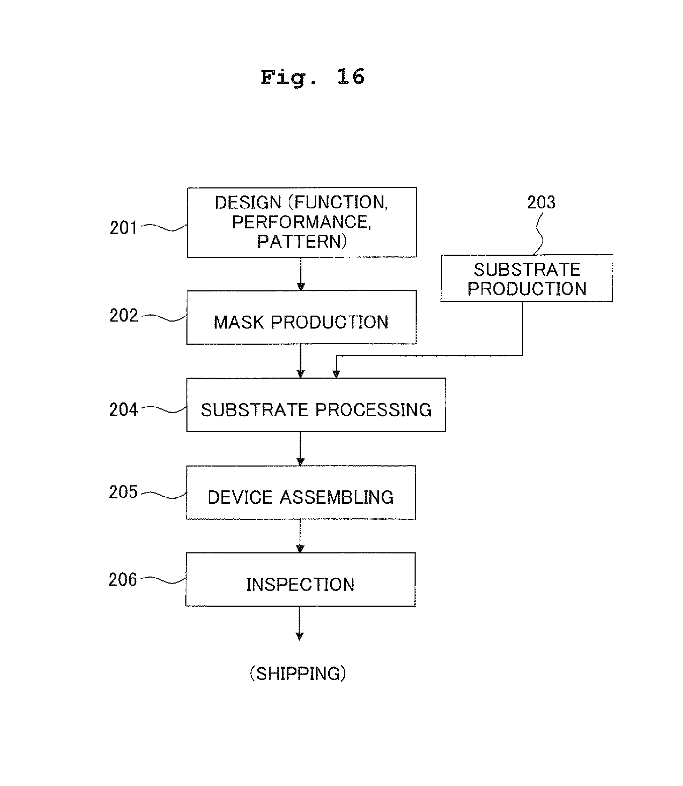

As shown in Fig. 16, the microdevice such as a semiconductor device is produced and shipped by performing a step (201) of designing the function and the performance of the microdevice; a step (202) of manufacturing a mask (reticle) based on the designing step; a step (203) of producing a substrate as a base material for the device; a substrate-processing step (204) including, for example, a step of exposing the substrate with the pattern of the mask by the exposure apparatus EX, EX' of the embodiment described above, a step of developing the exposed substrate, a step of heating (curing) and etching the developed substrate, etc.; a step (205) of assembling the device (including processing processes such as a dicing step, a bonding step, and a packaging step); an inspection step (206); and the like.

The substrate P, which is usable in the respective embodiments described above, is not limited to only the semiconductor wafer for producing the semiconductor device. Those applicable include a glass substrate for a display device, a ceramic wafer for a thin film magnetic head, a master plate (synthetic silica glass, silicon wafer) for a mask or a reticle to be used for the exposure apparatus, a film member, and the like. Further, the shape of the substrate P is not limited to only the circular shape, and may be any other shape including rectangular shapes, etc.

In the respective embodiments described above, the mask, on which the transferring pattern is formed, is used. However, instead of such a mask, it is also appropriate to use an electronic mask for forming a transmissive pattern or a reflective pattern based on an electronic data of the pattern to be subjected to the exposure as disclosed, for example, in United States Patent No. 6,778,257. The electronic mask is also referred to as "variable shaped mask" ("active mask", or "image generator"), which includes DMD (Digital Micro-mirror Device) as a kind of the no light-emitting image display device (spatial light modulator), etc. DMD has a plurality of reflecting elements (micro-mirrors) which are driven based on a predetermined electronic data. The plurality of reflecting elements are arranged in a two-dimensional matrix form on a surface of DMA, and are driven in element by element (individually) to reflect and deflect the exposure light. Angles of the reflecting surfaces of the respective reflecting elements are adjusted. The operation of DMD may be controlled by the controller CONT. The controller CONT drives the reflecting elements of DMD based on the electronic data (pattern information) corresponding to the pattern to be formed on the substrate P, and patterns the exposure light radiated by the illumination system IL by the reflecting elements. By using DMD, it is unnecessary to perform an exchange operation for the mask and a positional adjustment operation for the mask on the mask stage when the pattern is changed, as compared with the case in which the exposure is performed by using the mask (reticle) formed with the pattern. Therefore, it is possible to perform the exposure operation more efficiently. In the case of the exposure apparatus using the electronic mask, it is enough only that the substrate is moved in the X axis direction and the Y axis direction by the substrate stage, without providing the mask stage. The exposure apparatus using DMD is disclosed, for example, in Japanese Patent Application Laid-open Nos. 8-313842 and 2004-304135 in addition to above-mentioned United States Patent No. 6,778,257. The contents of United States Patent No. 6,778,257 is incorporated herein by reference within a range of permission of the domestic laws and ordinances of the designated state or the selected state.

As for the exposure apparatus EX, EX', the present invention is also applicable to a scanning type exposure apparatus (scanning stepper) of the step-and-scan system for performing the scanning exposure with a pattern of the mask M by synchronously moving the mask M and the substrate P, as well as to a projection exposure apparatus (stepper) of the step-and-repeat system for performing the full field exposure with the pattern of the mask M in a state that the mask M and the substrate P are allowed to stand still, while successively step-moving the substrate P.

As for the type of the exposure apparatus EX, EX', the present invention is not limited to the exposure apparatus for the semiconductor device production for exposing the substrate P with the semiconductor device pattern. The present invention is also widely applicable to an exposure apparatus for producing the liquid crystal display device or for producing the display as well as an exposure apparatus for producing, for example, a thin film magnetic head, a micromachine, MEMS, a DNA chip, an image pickup device (CCD), a reticle, or a mask, etc.

It is not necessarily indispensable that the exposure apparatus of the present invention and the exposure apparatus to which the maintenance method and the exposure method of the present invention are applied are provided with the projection optical system. It is enough that the exposure apparatus is provided with any optical member for guiding the exposure light from the light source to the substrate within a range in which the present invention can be carried out. It is also allowable that the illumination optical system and/or the light source is/are provided separately from the exposure apparatus. It is also possible to omit the mask stage and/or the substrate stage depending on the exposure system as described above.

The present invention is also applicable to an exposure apparatus of the multi-stage type provided with a plurality of substrate stages as disclosed, for example, in Japanese Patent Application Laid-open No. 10-163099, Japanese Patent Application Laid-open No. 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407. In this case, the cleaning is carried out for the plurality of substrate stages respectively. The contents of the above-identified United States Patents are incorporated herein by reference within a range of permission of the domestic laws and ordinances of the designated state or the selected state in relation to the exposure apparatus of the multi-stage type.

In the case of the projection optical system of each of the embodiments described above, the optical path space (liquid immersion space), which is located on the image plane side of the optical element arranged at the end portion of the projection optical system, is filled with the liquid. However, it is also possible to adopt a projection optical system in which the optical path space on the mask side of the optical element arranged at the end portion is also filled with the liquid, as disclosed, for example, in International Publication No. 2004/019128. Further, the present invention is also applicable to an exposure apparatus of the liquid immersion type in which the liquid immersion area, which is between the projection optical system and the substrate, is held or retained by an air curtain arranged around the liquid immersion area.

The present invention is also applicable to an exposure apparatus in which a line-and-space pattern is formed on the substrate P by forming interference fringes on the substrate P as disclosed, for example, in International Publication No. 2001/035168. Also in this case, the exposure light is irradiated onto the substrate P through the liquid disposed between the optical member and the substrate P.

In the respective embodiments described above, it is not necessarily indispensable that the liquid supply section and/or the liquid recovery section is/are provided on the exposure apparatus. For example, any equipment of the factory or the like in which the exposure apparatus is installed may be substitutively used. The structures of the exposure apparatus and the attached equipment required for the liquid immersion exposure are not limited to the structures as described above. It is possible to use those described, for example, in European Patent Publication No. 1420298, International Publication Nos. 2004/055803 and 2004/057590, International Publication No. 2005/029559 (corresponding to United States Patent Application Publication No. 2006/0231206), International Publication No. 2004/086468 (corresponding to United States Patent Application Publication No. 2005/0280791), and Japanese Patent Application Laid-open No. 2004-289126 (corresponding to United States Patent No. 6,952,253). The contents of, for example, the United States Patents and United States Patent Application Publications identified above are incorporated herein by reference within a range of permission of the domestic laws and ordinances of the designated state or the selected state in relation to the liquid immersion mechanism of the liquid immersion exposure apparatus and any apparatus equipped thereto.

In the embodiments described above, it is also allowable to use, as the liquid 1 to be used for the liquid immersion method, a liquid having the refractive index with respect to the exposure light higher than that of water, for example, those having the refractive index of about 1.6 to 1.8. The liquid 1, which has the refractive index (for example, not less than 1.5) higher than that of pure water, includes certain liquids having the C-H bond or the O-H bond such as isopropanol having a refractive index of about 1.50 and glycerol (glycerin) having a refractive index of about 1.61; certain liquids (organic solvents) such as hexane, heptane, and decane; decalin (decahydronaphthalene) having a refractive index of about 1.60; and the like. As for the liquid 1, it is also allowable to use those obtained by mixing arbitrary two or more liquids of the foregoing liquids, and it is also allowable to use those obtained by adding (mixing) at least one of the foregoing liquids to (with) pure water. Further, as for the liquid 1, it is also allowable to use those obtained by adding (mixing) base or acid such as H⁺, Cs⁺, K⁺, Cl⁻, SO₄²⁻, and PO₄²⁻ to (with) pure water, and it is also allowable to use those obtained by adding (mixing) fine particles of Al oxide or the like to (with) pure water. As for the liquid 1, it is preferable to use those which have a small coefficient of light absorption, which have a small temperature dependency, and which are stable against the photosensitive material (or, the top coat film, the antireflection film, or the like) coated on the surface of the substrate P and/or the projection system PL. As for the liquid 1, it is also possible to use a supercritical fluid. As for the substrate P, it is possible to provide the top coat film, etc. which protects the photosensitive material and the base material from the liquid.

On the other hand, the optical element (terminal end optical element) 2 of the projection optical system PL may be formed of, for example, silica glass (silica) or any single crystal material of a fluorine compound such as barium fluoride, strontium fluoride, lithium fluoride, and sodium fluoride instead of calcium fluoride.
Alternatively, the optical element (terminal end optical element) 2 may be formed of a material having a refractive index (for example, not less than 1.6) higher than those of silica glass and calcium fluoride. Those usable as the material having the refractive index of not less than 1.6 include sapphire, germanium dioxide, etc. as disclosed, for example, in International Publication No. 2005/059617, and potassium chloride (refractive index: about 1.75) as disclosed in International Publication No. 2005/059618.

In a case that the liquid immersion method is used, it is also appropriate that the optical path on the object plane side of the terminal end optical element is also filled with the liquid, in addition to the optical path on the image plane side of the terminal end optical element as disclosed, for example, in International Publication No. 2004/019128 (corresponding to United States Patent Application Publication No. 2005/0248856). Further, a thin film, which has the lyophilic or liquid-attractive property and/or the anti-dissolution function, may be formed on a part (including at least the contact surface which comes into contact with the liquid) or all of the surface of the terminal end optical element. The silica glass has a high affinity for the liquid, and any anti-dissolution film is not required for the silica glass as well. However, for calcium fluoride, it is preferable to form at least the anti-dissolution film.

In the respective embodiments described above, the ArF excimer laser is used as the light source for the exposure light EL. However, it is also allowable to use a high harmonic wave-generating device which includes a solid laser light source such as a DFB semiconductor laser or a fiber laser; a light-amplifying section having a fiber amplifier or the like; a wavelength-converting section; etc., and which outputs a pulse light beam having a wavelength of 193 nm, as disclosed, for example, in International Publication No. 1999/46835 (corresponding to United States Patent No. 7,023,610). Further, in the respective embodiments described above, the projection area (exposure area) is rectangular. However, it is also allowable to adopt any other shape including circular arc-shaped, trapezoidal, parallelogramic, rhombic shapes, etc.

Further, the present invention is also applicable to an exposure apparatus in which patterns of two masks are combined on the substrate via the projection optical system, and one shot area on the substrate is subjected to the double exposure substantially simultaneously by one time of the scanning exposure as disclosed, for example, in Published Japanese Translation of PCT International Publication for Patent Application No. 2004-519850 (corresponding to United States Patent No. 6,611,316). As described above, the present invention is not limited to the foregoing embodiments, and may be embodied in other various forms or constructions within a range without deviating from the gist or essential characteristics of the present invention.

As described above, the exposure apparatus EX, EX' according to the embodiment of the present invention is produced by assembling the various subsystems including the respective constitutive elements as defined in claims so that the predetermined mechanical accuracy, electric accuracy and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include the mechanical connection, the wiring connection of the electric circuits, the piping connection of the air pressure circuits in correlation with the various subsystems, etc. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness, etc. are managed.

As for various United States Patents and United States Patent Application Publications referred to in this specification, the contents thereof are incorporated herein by reference within a range of permission of the domestic laws and ordinances of the designated state or the selected state, in relation to those other than those having been specifically and explicitly incorporated herein by reference as well.

### INDUSTRIAL APPLICABILITY

According to the present invention, it is possible to efficiently judge whether or not the abnormality is present in at least a part of the liquid contact portion of the exposure apparatus for performing the exposure with the liquid immersion method. Therefore, if the abnormality is present, for example, the exposure is stopped to perform the cleaning, etc., to thereby decrease the amount of the foreign matter in the liquid of the liquid immersion area during the exposure to be performed thereafter, thus making it possible to produce the device highly accurately. According to the present invention, it is possible to easily judge whether or not the state of the substrate as the exposure objective or the state of the film of the substrate is adequate for the exposure based on the liquid immersion method, without actually performing the exposure. Thus, the throughput of the device production is improved. Therefore, the present invention can remarkably contribute to the development of the precision mechanical equipment industry including the semiconductor industry of our country.

## Claims

1. An exposure method for exposing a substrate with an exposure light via an optical member and a liquid, the exposure method comprising:
a first step of storing first observation information obtained by optically observing a state of at least a part of a detection objective portion of a liquid contact portion which comes into contact with the liquid in a predetermined operation;
a second step of obtaining second observation information by optically observing a state of the detection objective portion after the predetermined operation; and
a third step of comparing the first observation information and the second observation information to judge whether abnormality of the detection objective portion is present or absent.

2. The exposure method according to claim 1, wherein a space between the optical member and the substrate is filled with the liquid to form a liquid immersion space, and the substrate is exposed with the exposure light via the optical member and the liquid.

3. The exposure method according to claim 1 or 2, further comprising a fourth step of stopping an exposure operation when the abnormality is present in the third step.

4. The exposure method according to any one of claims 1 to 3, wherein the presence or absence of the abnormality, which is judged in the third step, is presence or absence of a foreign matter at the detection objective portion.

5. The exposure method according to any one of claims 1 to 4, wherein an alignment sensor of an image processing system is used to detect a position of an alignment mark on the substrate so as to optically observe the state of the detection objective portion.

6. The exposure method according to claim 5, wherein the second step is executed when the position of the alignment mark on the substrate is detected by using the alignment sensor.

7. The exposure method according to any one of claims 1 to 6, wherein an image pickup device, which is provided on a stage arranged opposite to the optical member, is used to optically observe the state of the detection objective portion.

8. The exposure method according to any one of claims 1 to 7, wherein the liquid contact portion comes into contact with the liquid at least during the exposure of the substrate.

9. The exposure method according to any one of claims 1 to 8, wherein the liquid contact portion includes at least a part of a liquid immersion space-forming member which fills a space between the optical member and the substrate to form a liquid immersion space.

10. The exposure method according to claim 9, wherein the detection objective portion includes at least one of a supply port and a recovery port, for the liquid, of the liquid immersion space-forming member.

11. The exposure method according to any one of claims 1 to 10, wherein the liquid contact portion includes at least a part of a movable member which is arranged opposite to the optical member.

12. The exposure method according to claim 11, wherein the detection objective portion includes a measuring portion and/or a flat surface of the movable member.

13. The exposure method according to any one of claims 1 to 10, wherein the second step is executed after an exposure operation for the substrate.

14. The exposure method according to any one of claims 1 to 11, further comprising a step of cleaning the liquid contact portion when the abnormality is present in the third step.

15. An exposure method for exposing a substrate with an exposure light via an optical member and a liquid, the exposure method comprising:
detecting information about a state of a liquid contact portion which comes into contact with the liquid in a predetermined operation; and
detecting information about abnormality of the liquid contact portion based on the detected information about the state and reference information about a state of the liquid contact portion before the predetermined operation.

16. The exposure method according to claim 15, wherein the liquid contact portion includes at least one of a liquid immersion space-forming member which forms a liquid immersion space by filling a space between the optical member and the substrate with the liquid, a movable member which is arranged opposite to the optical member, and the optical member.

17. The exposure method according to claim 16, wherein information about a state of the movable member is detected by a mark-detecting system which detects a mark on the substrate.

18. The exposure method according to claim 17, wherein the detected information about the movable member includes information about a measuring portion and/or a flat surface of the movable member.

19. The exposure method according to claim 17 or 18, wherein the movable member includes at least one of a first stage which holds the substrate and a second stage which is movable independently from the second stage.

20. The exposure method according to any one of claims 16 to 19, wherein the information about the state is detected by a detector which is arranged opposite to the liquid immersion space-forming member and/or the optical member.

21. The exposure method according to any one of claims 15 to 20, wherein judgment is made whether an exposure operation is to be stopped or continued depending on the information about the abnormality.

22. The exposure method according to any one of claims 15 to 21, wherein judgment is made whether or not maintenance is required for the liquid contact portion depending on the information about the abnormality.

23. The exposure method according to claim 22, wherein the maintenance includes cleaning and/or exchange of the liquid contact portion.

24. The exposure method according to any one of claims 15 to 23, wherein the reference information is detected before at least the predetermined operation.

25. The exposure method according to any one of claims 15 to 24, wherein the reference information includes at least information about a state of the liquid contact portion before the contact portion comes into contact with the liquid.

26. The exposure method according to any one of claims 15 to 25, wherein the predetermined operation includes at least an exposure operation for the substrate.

27. An exposure apparatus which exposes a substrate with an exposure light via an optical member and a liquid, the exposure apparatus comprising:
an optical device which optically observes a state of at least a part of a detection objective portion of a liquid contact portion which comes into contact with the liquid;
a storage device which stores observation information obtained by the optical device; and
a controller which compares a plurality of pieces of the observation information obtained by observing the detection objective portion a plurality of times by the optical device to judge whether abnormality of the detection objective portion is present or absent.

28. The exposure apparatus according to claim 27, wherein a space between the optical member and the substrate is filled with the liquid to form a liquid immersion space, and the substrate is exposed with the exposure light via the optical member and the liquid.

29. The exposure apparatus according to claim 27 or 28, wherein the controller stops an exposure operation when the abnormality of the detection objective portion is present.

30. The exposure apparatus according to any one of claims 27 to 29, wherein the optical device includes an alignment sensor of an image processing system which detects a position of an alignment mark on the substrate.

31. The exposure apparatus according to any one of claims 27 to 30, further comprising a stage which is arranged opposite to the optical member, wherein the optical device includes an image pickup device which is provided on the stage.

32. The exposure apparatus according to any one of claims 27 to 31, wherein the optical device includes a fluorescence microscope which detects fluorescence emitted when the exposure light is irradiated onto the detection objective portion.

33. The exposure apparatus according to any one of claims 27 to 32, wherein the optical device includes a spectrometer.

34. The exposure apparatus according to any one of claims 27 to 33, wherein the liquid contact portion comes into contact with the liquid at least during the exposure of the substrate.

35. The exposure apparatus according to any one of claims 27 to 34, wherein the liquid contact portion includes at least a part of a liquid immersion space-forming member which fills a space between the optical member and the substrate with the liquid to form a liquid immersion space.

36. The exposure apparatus according to claim 35, wherein the detection objective portion includes at least one of a supply port and a recovery port, for the liquid, of the liquid immersion space-forming member.

37. The exposure apparatus according to any one of claims 27 to 36, wherein the liquid contact portion includes at least a part of a measuring member arranged opposite to the optical member.

38. The exposure apparatus according to claim 37, further comprising a stage which is provided with the measuring member.

39. The exposure apparatus according to any one of claims 27 to 38, further comprising a cleaning member which cleans the detection objective portion.

40. An exposure apparatus which exposes a substrate with an exposure light via an optical member and a liquid, the exposure apparatus comprising:
an optical device which detects information about a state of a liquid contact portion which comes into contact with the liquid in a predetermined operation; and
a controller which detects information about abnormality of the liquid contact portion based on the detected information about the state and reference information about a state of the liquid contact portion before the predetermined operation.

41. The exposure apparatus according to claim 40, further comprising a movable member which is arranged opposite to the optical member, wherein the liquid contact portion includes at least one of the movable member and the optical member.

42. The exposure apparatus according to claim 41, wherein the optical device includes a mark-detecting system which detects a mark on the substrate, and information about a state of the movable member is detected by the mark-detecting system.

43. The exposure apparatus according to claim 41 or 42, wherein the optical device detects information about a measuring portion and/or a flat surface of the movable member.

44. The exposure apparatus according to any one of claims 41 to 43, wherein the movable member includes at least one of a first stage which holds the substrate and a second stage which is movable independently from the second stage.

45. The exposure apparatus according to any one of claims 40 to 44, further comprising a liquid immersion space-forming member which fills a space between the optical member and the substrate with the liquid to form a liquid immersion space, and the liquid contact portion includes the liquid immersion space-forming member.

46. The exposure apparatus according to claim 45, wherein the optical device includes a detector which is arranged opposite to the liquid immersion space-forming member and/or the optical member.

47. The exposure apparatus according to any one of claims 40 to 46, wherein the optical device includes at least one of an image pickup device, a fluorescence microscope, and a spectrometer.

48. The exposure apparatus according to any one of claims 40 to 47, wherein the controller judges whether an exposure operation is to be stopped or continued depending on the information about the abnormality.

49. The exposure apparatus according to any one of claims 40 to 48, further comprising a maintenance member which is usable to perform maintenance for the liquid contact portion, wherein the controller judges whether or not the maintenance is required depending on the information about the abnormality.

50. The exposure apparatus according to claim 49, wherein the maintenance member includes a cleaning member which cleans the liquid contact portion.

51. The exposure apparatus according to any one of claims 40 to 50, wherein the reference information is detected before at least the predetermined operation.

52. The exposure apparatus according to any one of claims 40 to 51, wherein the reference information includes at least information about a state of the liquid contact portion before the liquid contact portion comes into contact with the liquid.

53. A maintenance method for an exposure apparatus which exposes a substrate with an exposure light via an optical member and a liquid, the maintenance method comprising:
detecting information about a state of a liquid contact portion which comes into contact with the liquid in a predetermined operation; and
detecting information about abnormality of the liquid contact portion based on the detected information about the state and reference information about a state of the liquid contact portion before the predetermined operation.

54. The maintenance method according to claim 53, wherein the liquid contact portion includes at least one of a liquid immersion space-forming member which forms a liquid immersion space by filling a space between the optical member and the substrate with the liquid, a movable member which is arranged opposite to the optical member, and the optical member.

55. The maintenance method according to claim 54, wherein the detected information about the state includes information about a measuring portion and/or a flat surface of the movable member.

56. The maintenance method according to claim 54 or 55, wherein the detected information about the state includes information about a liquid recovery portion of the liquid immersion space-forming member.

57. The maintenance method according to any one of claims 53 to 56, wherein judgment is made whether or not maintenance is required for the liquid contact portion depending on the information about the abnormality.

58. The maintenance method according to claim 57, wherein the maintenance includes cleaning and/or exchange of the liquid contact portion.

59. An exposure method for exposing a substrate with an exposure light through a liquid, the exposure method comprising:
a first step of supplying the liquid to only a part of an area on the substrate;
a second step of recovering at least a part of the liquid supplied in the first step and inspecting a state of the recovered liquid;
a third step of inspecting a state of a film of the substrate; and
a fourth step of judging whether abnormality is present or absent in the substrate based on at least one of inspection results obtained in the second step and the third step.

60. The exposure method according to claim 59, wherein the substrate is arranged opposite to an optical member through which the exposure light passes, the liquid is supplied to a space between the optical member and the substrate, and the substrate is exposed with the exposure light via the optical member and the liquid.

61. The exposure method according to claim 59 or 60, further comprising a fifth step of stopping the exposure of the substrate when the abnormality is present in the fourth step.

62. The exposure method according to any one of claims 59 to 61, wherein the film of the substrate includes a film which is formed of a photosensitive material.

63. The exposure method according to any one of claims 59 to 62, wherein the film of the substrate includes a top coat which is coated on a photosensitive material.

64. The exposure method according to any one of claims 59 to 63, wherein presence or absence of exfoliation of the film of the substrate is inspected in the third step.

65. The exposure method according to any one of claims 59 to 64, wherein the area on the substrate, to which the liquid is supplied in the first step, includes at least a part of an edge portion of the substrate.

66. The exposure method according to any one of claims 59 to 65, wherein the third step includes a step of inspecting the state of the film on the substrate in a dry state.

67. The exposure method according to claim 66, wherein the third step includes a measuring step of measuring uneven thickness of the film of the substrate.

68. The exposure method according to claim 67, further comprising a sixth step of exfoliating the film of the substrate when the uneven thickness measured in the third step exceeds an allowable range.

69. The exposure method according to any one of claims 59 to 68, wherein the exposure is started for the substrate through the liquid when the abnormality is absent in the fourth step.

70. An exposure method for exposing a substrate with an exposure light via an optical member and a liquid, the exposure method comprising:
filling a space between the optical member and an object with the liquid to form a liquid immersion space and recovering the liquid in the liquid immersion space;
detecting information about the recovered liquid; and
detecting information about abnormality of a liquid contact portion which comes into contact with the liquid, based on the detected information about the recovered liquid.

71. The exposure method according to claim 70, wherein the object includes the substrate.

72. The exposure method according to claim 70 or 71, wherein information about a foreign matter in the recovered liquid is detected.

73. The exposure method according to any one of claims 70 to 72, wherein judgment is made whether an exposure operation is to be stopped or continued depending on the information about the abnormality.

74. A method for producing a device, comprising:
exposing a substrate by using the exposure method as defined in any one of claims 1 to 26 and 59 to 73;
developing the exposed substrate; and
processing the developed substrate.

75. An exposure apparatus which exposes a substrate with an exposure light through a liquid, the exposure apparatus comprising:
a liquid supply system which supplies the liquid to only a part of an area on the substrate;
a first detector which detects a state of a liquid obtained by recovering the liquid supplied by the liquid supply system;
a second detector which detects a state of a film of the substrate; and
a controller which judges whether abnormality of the substrate is present or absent based on at least one of detection results obtained by the first detector and the second detector.

76. The exposure apparatus according to claim 75, wherein the first detector includes a particle counter.

77. The exposure apparatus according to claim 75 or 76, wherein the second detector includes an alignment sensor.

78. The exposure apparatus according to any one of claims 75 to 77, wherein the controller starts liquid immersion exposure when there is no abnormality as judged from the detection results obtained by both of the first detector and the second detector.

79. The exposure apparatus according to any one of claims 75 to 78, wherein the controller judges whether the abnormality of the substrate is present or absent based on the detection results obtained by both of the first detector and the second detector.

80. The exposure apparatus according to any one of claims 75 to 79, further comprising a stage which holds the substrate, wherein the state of the film is detected at a circumferential edge portion of the substrate by the second detector while moving the stage.

81. An exposure apparatus which exposes a substrate with an exposure light via an optical member and a liquid, the exposure apparatus comprising:
a liquid immersion mechanism which forms a liquid immersion space by filling a space between the optical member and an object with the liquid and which recovers the liquid in the liquid immersion space;
a detecting device which detects information about the recovered liquid; and
a controller which detects information about abnormality of a liquid contact portion which comes into contact with the liquid, based on the detected information about the recovered liquid.

82. The exposure apparatus according to claim 81, wherein the object includes the substrate.

83. The exposure apparatus according to claim 81 or 82, wherein the detecting device detects information about a foreign matter in the recovered liquid.

84. The exposure apparatus according to claim 83, wherein the detecting device includes a particle counter.

85. The exposure apparatus according to any one of claims 81 to 84, wherein the controller judges whether an exposure operation is to be stopped or continued depending on the information about the abnormality.

86. A method for producing a device, comprising:
exposing a substrate by using the exposure apparatus as defined in any one of claims 27 to 52 and 75 to 85;
developing the exposed substrate; and
processing the developed substrate.

87. An exposure method for exposing a substrate with an exposure light via an optical member and a liquid, the exposure method comprising:
detecting information about a state of a liquid contact portion which comes into contact with the liquid in a predetermined operation; and
detecting information about abnormality of the liquid contact portion based on the detected information about the state.

88. The exposure method according to claim 87, wherein the detected information about the state includes information obtained by detecting the liquid contact portion with a fluorescence microscope.

89. An exposure apparatus which exposes a substrate with an exposure light via an optical member and a liquid, the exposure apparatus comprising:
an optical device which detects information about a state of a liquid contact portion which comes into contact with the liquid in a predetermined operation; and
a controller which detects information about abnormality of the liquid contact portion, based on the detected information about the state.

90. The exposure apparatus according to claim 89, wherein the optical device includes a fluorescence microscope.
